# EUROPEAN PATENT APPLICATION

(11) **EP 4 723 159 A2**
(43) Date of publication of application: **08.04.2026**
(21) Application number: 25205882.1
(22) Date of filing: 30.09.2025
(51) Int. Cl.: H01J 37/153, H01J 37/12, H01J 37/26

(54) **FOIL LENS CORRECTORS, CHARGED PARTICLE MICROSCOPE SYSTEMS INCLUDING THE SAME, AND ASSOCIATED METHODS**

(30) Priority: 02.10.2024 US 202418904582
(71) Applicant: FEI Company, Hillsboro, OR 97124 (US)
(72) Inventor: VASINA, Radovan, Brno (CZ); SEDA, Bohuslav, Blansko (CZ); GLAJC, Petr, Brno (CZ); RADLICKA, Tomás, Lomnice (CZ)
(74) Representative: Boult Wade Tennant LLP

(57) **Abstract**

Foil lens correctors, charged particle microscope systems including the same, and associated methods. In an example, a foil lens corrector is configured to generate an offsetting spherical aberration in a charged particle beam and includes a graphene foil. In an example, a CPM system includes a charged particle source and a foil lens corrector including a graphene foil. In an example, a method of operating a CPM system includes directing a charged particle beam to a specimen and operating a foil lens corrector to generate an offsetting spherical aberration in the charged particle beam. In an example, the charged particle beam is incident upon a foil of the foil lens corrector with a foil landing energy that is at least 5 keV and at most 80 keV and such that the charged particle beam is transmitted through the foil with a transmission ratio that is at least 20%.

## Description

### FIELD

The present disclosure relates generally to lens correctors for correcting a spherical aberration in charged particle beams of charged particle microscope systems, and associated methods.

### BACKGROUND

In the field of charged particle microscopy, the resolution of a specimen micrograph as imaged by a charged particle microscope (CPM) system in scanning probe mode is related to the minimum diameter of a charged particle beam that is focused upon a specimen. In practice, this minimum diameter may be limited by axial optical aberrations such as spherical aberration, chromatic aberration, and other aberrations introduced into the charged particle beam by optical elements of the CPM system. In particular, nonzero spherical and/or chromatic aberrations are unavoidable in an optical system of electromagnetic lenses in which electromagnetic fields are static and rotationally symmetric and in which no space charge exists on the optical axis. Some spherical aberration correctors seek to correct for spherical aberration through introduction of multipole electrostatic and magnetic fields, time dependent electromagnetic fields, and/or axial space charges; however, many such prior correction systems suffer from complexity and/or stability issues.

### SUMMARY

In a representative example, a foil lens corrector for correcting spherical aberration in a charged particle beam generated by a CPM system includes a foil and an electrode assembly. The foil is configured to be positioned in line with an optical axis of the CPM system. The electrode assembly is configured to generate a corrector electrostatic potential. The foil includes graphene, and the foil is configured to support a space charge such that the optical axis intersects the space charge. The foil lens corrector is configured to generate a corrector electrostatic potential that generates an offsetting spherical aberration in the charged particle beam to at least partially correct a spherical aberration in the charged particle beam.

In another representative example, a CPM system includes a charged particle source configured to generate a charged particle beam and a foil lens corrector for correcting spherical aberration in the charged particle beam. The foil lens corrector includes a foil configured to be positioned in line with an optical axis of the CPM system and an electrode assembly configured to generate a corrector electrostatic potential. The foil includes graphene, and the foil is configured to support a space charge such that the optical axis intersects the space charge. The foil lens corrector is configured such that the corrector electrostatic potential generates an offsetting spherical aberration in the charged particle beam to at least partially correct a spherical aberration in the charged particle beam.

In another representative example, a method of operating a CPM system that includes a foil lens corrector includes directing a charged particle beam along an optical axis to a specimen positioned in a specimen plane and operating a foil lens corrector positioned along the optical axis to generate a corrector electrostatic potential that generates an offsetting spherical aberration in the charged particle beam. The operating the foil lens corrector includes directing the charged particle beam to a foil of the foil lens corrector such that the charged particle beam is incident upon the foil with a foil landing energy that is at least 5 kiloelectronvolts (keV) and at most 80 keV and such that the charged particle beam is transmitted through the foil with a transmission ratio that is at least 20%.

The foregoing and other objects, features, and advantages of the disclosed technology will become more apparent from the following detailed description, which proceeds with reference to the accompanying figures.

### BRIEF DESCRIPTION OF THE DRAWINGS

FIG. 1 is a schematic illustration of a CPM system according to an example.
FIG. 2A is a schematic cross-sectional illustration of a foil lens corrector according to an example.
FIG. 2B is a schematic cross-sectional illustration of a region of FIG. 2A indicated with a dashed circle labeled 2B.
FIG. 3 is a schematic illustration of a CPM system that produces a charged particle beam with a finite beam convergence angle according to an example.
FIG. 4 is an illustration of ray trajectories of a charged particle beam that traverses a CPM system according to an example.
FIG. 5A is a graph illustrating an electrostatic potential magnitude as measured along the optical axis of a CPM system with a foil lens corrector and with a foil operatively installed in the foil lens corrector according to an example.
FIG. 5B is a graph illustrating an electrostatic potential magnitude as measured along the optical axis of a CPM system with a foil lens corrector and with a foil removed from the foil lens corrector according to an example.
FIG. 6 is a graph illustrating components of an electrostatic potential magnitude as measured along the optical axis of a CPM system within a foil lens corrector according to an example.
FIG. 7A is a graph illustrating a steering curve representing the relationship between a first electrode voltage and a second electrode voltage at a constant value of a spherical aberration coefficient according to an example.
FIG. 7B is a graph illustrating the dependence of a third order spherical aberration coefficient generated by a foil lens corrector in a charged particle beam upon a first electrode voltage according to an example.
FIG. 7C is a graph illustrating the dependence of a characteristic beam diameter of a charged particle beam upon a first electrode voltage according to an example.
FIG. 7D is a graph illustrating the dependence of a spherical aberration coefficient upon a first electrode voltage according to an example.
FIG. 8 is an image of a graphene foil according to an example.
FIG. 9 is a graph illustrating the dependence of a charged particle beam transmission ratio upon a foil landing energy of the charged particle beam upon a foil of a foil lens corrector according to an example.
FIG. 10 is a cross-sectional illustration of a foil lens corrector including a corrector housing according to an example.
FIG. 11 is a cross-sectional illustration of a CPM system including a foil lens corrector and a corrector heater according to an example.
FIG. 12 is an image of a portion of a foil lens corrector and a corrector heater in a disassembled configuration according to an example.
FIG. 13 is a flow chart depicting methods of operating a CPM system including a foil lens corrector according to an example.
FIG. 14 is a schematic representation of a computing system that may be used to perform one or more methods of the present disclosure according to an example.

### DETAILED DESCRIPTION

The present disclosure generally is directed to foil lens correctors for at least partially correcting (e.g., nullifying) at least a portion of a spherical aberration in a charged particle beam produced by a CPM system at a focus location, as well as to CPM systems including such correctors and associated methods. As described in more detail herein, such foil lens correctors may operate by generating a negative spherical aberration in the charged particle beam that can serve to counteract a positive spherical aberration introduced by optical elements of the CPM system.

In many prior CPM designs, spherical and/or chromatic axial aberrations are unavoidable. In particular, Scherzer's theorem states that positive spherical and chromatic aberration are always present in an electromagnetic lensing system that satisfies the following conditions (referred to herein as the Scherzer conditions): (1) the electromagnetic fields are rotationally symmetric; (2) the electromagnetic fields are static; (3) no space charges are present on the optical axis; and (4) a charged particle beam traveling along the optical axis does not change direction (e.g., in contrast to an electron mirror).

Some prior CPM systems have sought to violate one or more of these conditions in order to eliminate spherical and/or chromatic aberrations. For example, various transmission electron microscopes (TEMs) have employed systems with multipole symmetry that violate the first Scherzer condition. Such designs, however, often suffer from complexity and/or stability issues.

Other prior CPM systems have sought to violate the third Scherzer condition by introducing a conductive foil in the path of the charged particle beam. Such foils, however, can effectively limit the beam current at the specimen as a result of a relatively low charged particle beam transmissivity.

As described in more detail below, foil lens correctors according to the present disclosure address these shortcomings of prior systems through the use of a simple structure that offers high charged particle beam transmissivity and that allows for correction of spherical aberrations with a small number of degrees of freedom to control. In particular, in various examples, the foil lens corrector includes a graphene foil that operates to violate the third Scherzer condition while allowing for high transmissivity of the charged particle beam through the foil.

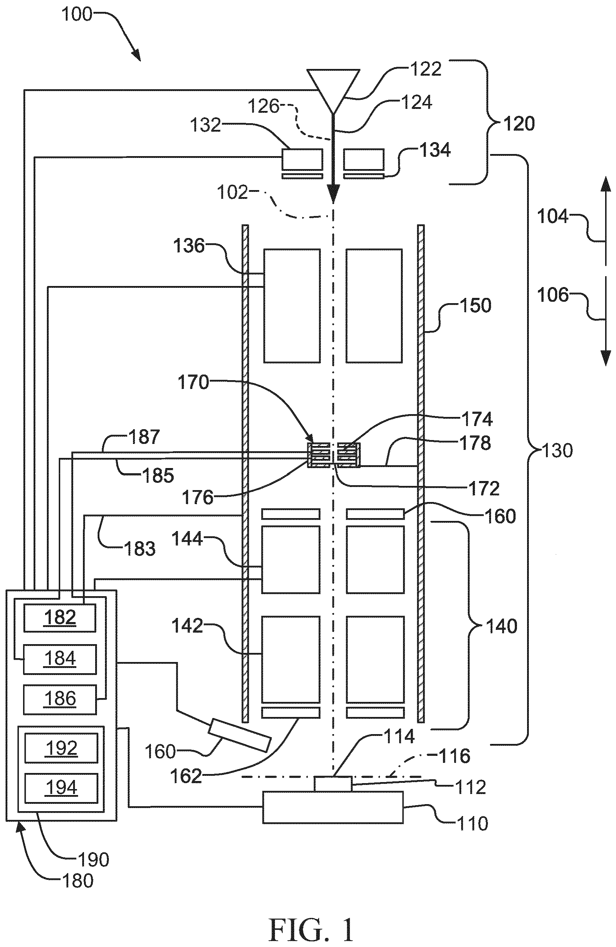

FIG. 1 is a schematic cross-sectional representation of an example of a CPM system 100 according to the present disclosure. The CPM system 100 can include a charged particle source module 120 with a charged particle source 122, a specimen holder 110 configured to support a specimen 112, and a beam directing system 130. The charged particle source 122 can generate and/or emit a charged particle beam 124 along an optical axis 102 toward the specimen 112, while the beam directing system 130 can shape, modulate, focus, and/or direct the charged particle beam 124 to the specimen 112. As shown in FIG. 1, the CPM system includes a foil lens corrector 170 for at least partially correcting a spherical aberration in the charged particle beam 124.

In the present disclosure, various components of CPM systems and/or of foil lens correctors are illustrated in cross-section for clarity. In general, it is to be understood that the illustrated structures extend fully around an axis of symmetry, such as around an illustrated optical axis, in a rotationally symmetric manner as appropriate. For example, it is to be understood that FIG. 1 represents a cross-sectional view of a structure in which the foil lens corrector 170 extends fully circumferentially around the optical axis 102.

The CPM system 100 can represent an example of any of a variety of CPM systems. In particular, the present disclosure generally is directed to examples in which the CPM system 100 includes and/or is a SEM system and/or in which the charged particle beam 124 is an electron beam 124 that is guided to and focused onto the specimen 112 by the beam directing system 130. In such examples, the (focused) electron beam 124 can interact with the specimen 112 in such a manner as to cause various types of "stimulated" radiation to emanate from the specimen 112, including (for example) secondary electrons, backscattered electrons, X-rays, and/or and optical radiation (cathodoluminescence). In an example in which the charged particle beam 124 is an electron beam 124, the charged particle source 122 also may be referred to as an electron source and/or an electron emitter.

While the present disclosure generally relates to examples in which the CPM system 100 is an SEM system, this is not required of all examples, and it additionally is within the scope of the present disclosure that the systems and apparatuses disclosed herein can be used in conjunction with any suitable CPM configuration, examples of which include a transmission electron microscope (TEM), a scanning transmission electron microscope (STEM), etc. and any suitable combinations thereof.

The charged particle source module 120 and/or the beam directing system 130 can include any of a variety of components and/or elements for operating upon the charged particle beam 124. For example, and as shown in FIG. 1, the charged particle source module 120 can include an energy selection apparatus 132 configured to limit an energy spread of the charged particle beam 124 and/or an aperture 134 configured to limit an angular extent of the charged particle beam 124.

In various examples, the energy selection apparatus 132 can be configured to at least partially limit a chromatic aberration of the charged particle beam 124 downstream of the charged particle source module 120. For example, the energy selection apparatus 132 may be configured to transmit only a portion of the charged particle beam 124 that is characterized by a charged particle energy that is within a selected energy bandwidth. In some examples, the energy selection apparatus 132 includes and/or is a monochromator. In some examples, the energy selection apparatus 132 can include the aperture 134. Examples of energy selection apparatuses that may be used in conjunction with the systems and apparatuses of the present disclosure are disclosed in U.S. Patent No. 7,034,315, U.S. Patent No. 7,999,225, and U.S. Patent No. 9,741,525, the complete disclosures of which are incorporated by reference herein.

As additionally shown in FIG. 1, the beam directing system 130 can include a condenser lens assembly 136 configured to manipulate the charged particle beam 124 toward the specimen 112 and/or an objective lens assembly 140 with one or more objective lens elements 142 configured to focus the charged particle beam 124 upon the specimen 112. The beam directing system 130 and/or the objective lens assembly 140 can include one or more scanning deflectors 144 configured to deflect the charged particle beam 124, such as to scan the charged particle beam 124 relative to a surface of the specimen 112.

In various examples, the beam directing system 130 additionally or alternatively can include illuminators, objective lenses, projection lenses, condenser lenses, electrostatic/magnetic lenses, deflectors (e.g., scan coils), correctors (such as stigmators), etc. in any suitable combinations. As shown in FIG. 1, one or more elements of the charged particle source module 120 may be described as being components of the beam directing system 130.

As used herein, terms such as "upstream" and "downstream" are intended to refer to directions relative to the propagation of the charged particle beam 124. For example, and as shown in FIG. 1, various components, features, etc. of the CPM system 100 may be described with reference to an upstream direction 104 and/or a downstream direction 106. The upstream direction 104 is directed generally toward the charged particle source 122 and/or away from the specimen holder 110, while the downstream direction 106 is directed generally toward the specimen holder 110 and/or away from the charged particle source 122.

In the example of FIG. 1, the foil lens corrector 170 is positioned downstream of the condenser lens assembly 136 and upstream of the objective lens assembly 140. Accordingly, the condenser lens assembly 136 may operate to center the charged particle beam 124 upon the foil lens corrector 170.

In general, it may be desirable to position the foil lens corrector 170 upstream of at least a portion of the objective lens assembly 140 (e.g., upstream of the scanning deflectors 144). Specifically, such a configuration may ensure that the foil lens corrector 170 operates upon the charged particle beam 124 in a region in which the trajectory of the charged particle beam 124 is substantially stationary and/or is undeflected by optical elements such as the scanning deflectors 144.

Additionally, or alternatively, positioning the foil lens corrector 170 upstream of the scanning deflectors 144 may facilitate operating the CPM system 100 with a wide field of view. For example, such a configuration may ensure that the charged particle beam 124 is operatively aligned with the foil lens corrector 170 regardless of tilt of the charged particle beam 124 induced by the scanning deflectors 144. As examples, the CPM system 100 and/or the beam directing system 130 may be configured to scan the charged particle beam 124 across the surface of the specimen 112 to yield a field of view that is at least 50 nanometers (nm), at least 100 nm, at least 200 nm, at least 300 nm, at most 500 nm, at most 250 nm, at most 150 nm, and/or at most 75 nm.

The beam directing system 130 additionally can include a booster tube 150 configured to energize the charged particle beam 124 as the charged particle beam 124 passes through the booster tube 150. The booster tube 150 may be maintained at a booster tube voltage such that the booster tube generates an associated electrostatic field that energizes the charged particle beam 124 within the booster tube 150. As a more specific example, the charged particle beam 124 can be an electron beam, and the booster tube 150 can be maintained at a positive voltage (e.g., approximately 8000 V) to accelerate the electron beam within the booster tube 150.

Upon exiting the booster tube 150, the electrostatic field generated by the booster tube and extending downstream of the booster tube can decelerate the charged particle beam 124. In this manner, the charged particle beam 124 can exit the booster tube 150 with a significantly reduced energy such that the charged particle beam 124 is incident upon the specimen 112 with a specimen landing energy that is significantly smaller than the energy of the charged particle beam 124 within the beam directing system 130. The use of small specimen landing energies (e.g., on the order of tens or hundreds of eV) may be desirable to avoid damaging sensitive components of the specimen 112, while maintaining the charged particle beam 124 at a relatively high energy within the booster tube 150 can avoid dispersion due to Coulombic interactions and/or charging effects associated with the beam directing system 130. In the present disclosure, the booster tube 150 additionally or alternatively may be referred to as an accelerator tube 150.

Additional examples of booster tubes that may be used in conjunction with the systems and apparatuses of the present disclosure are disclosed in U.S. Patent No. 5,146,090, the complete disclosure of which is incorporated by reference herein.

In practice, the specimen landing energy of the charged particle beam 124 can be selected and/or varied via corresponding variation of the acceleration voltage of the charged particle beam 124 emitted by the charged particle source 122. In particular, the specimen landing energy of the charged particle beam 124 may be equal to the difference between the acceleration voltage of the charged particle beam 124 at the charged particle source 122 and a bias voltage applied to the specimen 112. In some examples, it may be desirable to maintain the specimen 112 at an electrical ground to avoid damaging the specimen 112 and/or otherwise interfering with specimen analysis. Accordingly, in such examples, the landing energy of the charged particle beam 124 may be primarily and/or exclusively determined by and/or equal to the acceleration voltage at which the charged particle source 122 emits the charged particle beam 124. Because the electrostatic field generated by the booster tube 150 is a conservative field, the booster tube 150 may have zero (or negligible) effect on the landing energy (e.g., relative to the acceleration voltage).

The CPM system 100 may be configured such that the charged particle beam 124 is incident upon the specimen 112 with any of a variety of specimen landing energies. As examples, the specimen landing energy may be at least 10 eV, at least 50 eV, at least 100 eV, at least 300 eV, at least 500 eV, at least 1000 eV, at least 5000 eV, at least 10 keV, at most 50 keV, at most 30 keV, at most 7000 eV, at most 2000 eV, at most 1500 eV, at most 700 eV, at most 200 eV, at most 70 eV, at most 20 eV, 10-100 eV, 50-500 eV, 100-1000 eV, 300-1500 eV, 500-2000 eV, 1000 eV-30 keV, and/or 5000 eV-50 keV. In general, at small values of the specimen landing energy, the total aberration of the charged particle beam 124 may be dominated by chromatic aberration effects. Accordingly, the use of the foil lens corrector 170 to correct for spherical aberrations may be particularly in a regime of specimen landing energies in which spherical aberration is more prevalent, such as specimen landing energies greater than 1000 eV.

The objective lens assembly 140 may operate to direct (e.g., converge and/or focus) the charged particle beam 124 to a focus location 114 (e.g., a location on or near the specimen 112). The objective lens assembly 140 can operate to focus the charged particle beam 124 by generating one or more electrostatic and/or magnetic fields that deflect rays of the charged particle beam 124 toward a common focus location (e.g., the focus location 114). In particular, the objective lens element(s) 142 can be configured to generate a lens electrostatic field and/or a lens magnetic field, each of which may operate to at least partially direct and/or focus the charged particle beam 124 to the focus location 114. In some examples, magnetic focusing can offer enhanced optical properties of the focused charged particle beam 124 (e.g., smaller aberrations) relative to purely electrostatic focusing.

The focus location 114 can include, be, and/or correspond to any location (e.g., a point, a region, a line, a plane, a volume, etc.) at which the charged particle beam is sufficiently focused upon the specimen 112 and/or another component of the CPM system 100 as described herein. As an example, the focus location 114 can include and/or be a focal point and/or a focal plane associated with the objective lens assembly 140. Accordingly, as used herein, the focus location 114 additionally or alternatively may be referred to as a focal point 114 and/or as a focal plane 114. Additionally, or alternatively, the focus location 114 can correspond to a location in a specimen plane 116 at which at least a portion of the specimen 112 is located.

In examples in which the focus location 114 includes at least a portion of a focal plane, it is to be understood that such a focal plane is not necessary perfectly planar. For example, the focal plane may be subject to field curvature associated with the objective lens assembly 140. In some examples, the focus location 114 additionally or alternatively can correspond to a location (e.g., a location along the optical axis 102) at which the charged particle beam 124 exhibits a minimum diameter and/or a minimum degree of optical aberrations.

The CPM system 100 can include one or more electron and/or photon detectors configured to detect electrons emitted from the specimen 112. For example, and as shown in FIG. 1, the CPM system 100 can include a secondary electron detector 160 configured to detect secondary electrons emitted from the specimen 112 and/or a backscattered electron detector 162 configured to detect backscattered electrons. In some examples, and as shown in FIG. 1, the secondary electron detector 160 and/or the backscattered electron detector 162 can be positioned within the optical column (e.g., within the booster tube 150). In some examples, the positive electrostatic potential field associated with the booster tube 150 can accelerate the electrons toward the secondary electron detector 160 and/or the backscattered electron detector 162 within the booster tube 150.

A measurement characterizing the electrons incident upon the secondary electron detector 160 and/or the backscattered electron detector 162 (e.g., characterizing the intensity and/or energy of such detected electrons) can provide an indication of various physical properties of the specimen 112, such as a geometrical structure of the specimen 112 and/or a chemical composition of the specimen 112 at a location upon which the charged particle beam 124 is incident upon the specimen 112 (e.g., at the focus location 114). Such measurements thus may be used to form an image (e.g., a graphical representation) of the specimen at the focus location. A spatial resolution with which the CPM system 100 can characterize the specimen 112 thus is at least partially based upon a minimum size (e.g., a minimum diameter) of the charged particle beam 124 at the focus location 114 and/or in the specimen plane 116.

Scanning the charged particle beam 124 across a surface of the specimen 112 thus can yield an image and/or other representation of the specimen 112 in the region scanned. Such scanning may be accomplished in any suitable manner. For example, the scanning deflectors 144 can operate to deflect the charged particle beam 124 to scan the charged particle beam 124 across the specimen 112 and/or to move the focus location 114 relative to the specimen 112. Additionally, or alternatively, the specimen holder 110 can be configured to rotate and/or translate the specimen 112 through one or more dimensions to move the specimen 112 relative to the focus location 114. Such movement (e.g., translation) of the specimen 112 and/or scanning of the charged particle beam 124 thus can allow selected portions of the specimen 112 to be irradiated/imaged/inspected by the charged particle beam 124 traveling along the optical axis 102.

As shown in FIG. 1, the foil lens corrector 170 includes a foil 172 that is positioned in line with the optical axis 102 and an electrode assembly 174 configured to generate a corrector electrostatic potential that is at least substantially confined to a single side of the foil 172 (e.g., an upstream side of the foil 172 or a downstream side of the foil 172). The corrector electrostatic potential can operate as a lens upon the charged particle beam 124 to modulate a spherical aberration of the charged particle beam 124 as described herein.

As described in more detail below, the foil 172 can operate to shape and/or constrain the corrector electrostatic potential. In particular, the foil 172 can serve as a conductive surface and/or region that supports a space charge that extends to and/or around the optical axis 102. In this manner, the foil 172 can operate to violate the third Scherzer condition described above, thereby allowing for (in principle) the elimination of spherical aberrations in the charged particle beam 124.

In various examples, it may be desirable to configure the foil 172 such that the foil 172 is highly electrically conductive to support a free flow of charge and/or to avoid charging of the foil 172. It also may be desirable to configure the foil 172 such that the foil 172 itself does not significantly interact with the charged particle beam 124 and/or affect a trajectory of the charged particle beam 124, such as through scattering interactions. Accordingly, in various examples according to the present disclosure, the foil 172 includes and/or is a foil of graphene, which can offer high electrical conductivity and a low degree of interaction with the charged particle beam 124. Configuring the foil 172 in this manner thus may render the foil 172 at least substantially transparent to charged particles (e.g., electrons) of the charged particle beam 124.

In various examples, the foil 172 can include and/or be single-layer graphene, two-layer graphene, three-layer graphene, or more than three layers of graphene. In general, a graphene foil of fewer layers (i.e., of carbon atoms) may beneficially correspond to a greater degree of charged particle transmission through the foil but may be correspondingly more difficult to prepare and/or handle.

While the present disclosure generally is directed to examples in which the foil 172 includes and/or is a graphene foil, this is not required of all examples, and it additionally is within the scope of the present disclosure that the foil 172 can be formed of any suitable material. As additional examples, the foil 172 can include and/or be a foil of molybdenum disulfide, tungsten disulfide, and/or any other material that offers high degrees of planarity, electrical conductivity, and/or charged particle beam transmission.

As used herein, the term "foil" is intended to refer to any material form and/or structure that is characterized by a thickness that is sufficiently small relative to its length and width dimensions so as to be well approximated as a two-dimensional structure. As an example, a foil may be characterized by length and/or width dimensions that are at least 10,000 times greater than a thickness dimensions, at least 100,000 times greater than the thickness dimension, and/or at least 1,000,000 times greater than the thickness dimensions. Additionally, or alternatively, a foil may be characterized by a thickness that is constant across an area of the foil to within 75% of a maximum thickness of the foil, to within 50% of the maximum thickness, and/or to within 25% of the maximum thickness.

A foil, such as a graphene foil, additionally or alternatively may be characterized with reference to a homogeneity of material composition and/or form thereof. For example, a graphene foil may include inhomogeneities in the form of different allotropic forms of carbon that vary in thickness relative to that of the graphene portion of the foil. Such inhomogeneities may be at least substantially benign with respect to the functionality of a foil lens corrector 170 including such a foil if such inhomogeneities are sufficiently sparse. Accordingly, in various examples, the foil 172 is characterized by an inhomogeneity density, defined as a proportion of an area of the foil 172 that is occupied by material inhomogeneities, that is at most 2%, at most 1%, and/or at most 0.1%.

The foil lens corrector 170 and/or the corrector electrostatic potential can be configured to generate a negative spherical aberration in the charged particle beam 124 as the charged particle beam 124 traverses the foil lens corrector 170. In particular, the negative spherical aberration generated by the foil lens corrector 170 can be configured to offset a positive spherical aberration that is introduced by other optical elements of the CPM system 100. As more specific examples, the negative spherical aberration generated by the foil lens corrector 170 may be characterized by a third order spherical aberration coefficient at the specimen plane 116 that is at least -20 millimeters (mm), at least -15 mm, at least -10 mm, at least -5 mm, at least -1 mm, at most 0 mm, at most -2 mm, at most -7 mm, at most -12 mm, and/or at most -17 mm.

Additionally, or alternatively, the foil lens corrector 170 and/or the corrector electrostatic potential can be configured to generate a positive spherical aberration in the charged particle beam 124 as the charged particle beam 124 traverses the foil lens corrector 170. In particular, the positive spherical aberration generated by the foil lens corrector 170 can be configured to offset a negative spherical aberration that is introduced by other optical elements of the CPM system 100. As more specific examples, the negative spherical aberration generated by the foil lens corrector 170 may be characterized by a third order spherical aberration coefficient at the specimen plane 116 that is at least 0 mm, at least 2 mm, at least 7 mm, at least 12 mm, at least 17 mm, at most 20 mm, at most 15 mm, at most 10 mm, at most 5 mm, and/or at most 1 mm.

In this manner, the foil lens corrector 170 can operate to counteract either or both of a positive spherical aberration and/or a negative spherical aberration that is generated in the charged particle beam 124 by one or more other optical elements of the CPM system 100. As a result, the CPM system 100 can operate to focus the charged particle beam 124 to the focus location 114 with negligible and/or zero spherical aberration. As examples, the CPM system 100 can operate to focus the charged particle beam 124 such that the charged particle beam 124 has a spherical aberration in the specimen plane 116 that is characterized by a third order spherical aberration coefficient with a magnitude that is at most 5 mm, at most 3 mm, at most 1 mm, at most 0.5 mm, and/or 0 mm.

In general, the (negative or positive) spherical aberration generated in the charged particle beam 124 by the foil lens corrector 170 may be referred to as an offsetting spherical aberration. The offsetting spherical aberration thus may be characterized by a spherical aberration coefficient (e.g., a third order spherical aberration coefficient) that is opposite in sign and at least substantially equal in magnitude to a spherical aberration coefficient characterizing the charged particle beam 124 at the specimen plane 116 when the foil lens corrector 170 is omitted from the CPM system 100. In general, in the present disclosure, the offsetting spherical aberration corresponds to a spherical aberration as measured in the specimen plane 116.

As shown in FIG. 1, the foil lens corrector 170 may be positioned within the booster tube 150, and/or may be electrically coupled to the booster tube 150, such as via an electrical lead 178. In particular, in some examples, the foil 172 is electrically coupled to the booster tube 150, such as via a corrector housing 176 of the foil lens corrector 170 that supports the foil 172. In such examples, the booster tube voltage may be regarded as a floating ground level relative to which the corrector electrostatic potential may be defined and/or measured.

In some examples, the corrector electrostatic potential can operate to reduce a magnitude of the electrostatic potential along the optical axis 102 at the location of the foil lens corrector 170 relative to a magnitude of the electrostatic potential along the optical axis 102 within the booster tube 150 away from the foil lens corrector 170. For example, the booster tube 150 may be configured to accelerate the charged particle beam 124 to a boosted potential along the optical axis 102 within the booster tube 150, and the foil lens corrector 170 may be configured such that a total electrostatic potential magnitude on the optical axis 102 within the foil lens corrector 170 is less than a magnitude of the boosted potential. The boosted potential may be related to (e.g., at least substantially equal to) the booster tube voltage, and/to a sum of the booster tube voltage and the energy with which the charged particle beam 124 exits the charged particle source module 120. As more specific examples, the boosted potential may be at least 4 keV, at least 6 keV, at least 8 keV, at least 10 keV, at least 12 keV, at most 14 keV, at most 11 keV, at most 9 keV, at most 7 keV, at most 5 keV, 4-9 keV, 6-11 keV, 8-14 keV, and/or 4-14 keV.

As shown in FIG. 1, the CPM system 100 further can include a controller 180 that is programmed and/or otherwise configured to at least partially control operation of the CPM system 100. For example, the controller 180 can at least partially control operation of the charged particle source 122 to produce the charged particle beam 124 and/or can at least partially control operation of at least a portion of the beam directing system 130. Additionally, or alternatively, the controller 180 can receive a signal from the secondary electron detector 160 and/or from the backscattered electron detector 162 that is representative of electrons that are emitted from a surface of the specimen 112, which may be used to produce an image and/or other representation of the specimen 112.

In some examples, the controller 180 also can at least partially control operation of the foil lens corrector 170 and/or of associated systems, such as by enabling selective and/or dynamic control of the booster tube voltage, the selectively and dynamically varying the booster tube voltage and/or the voltage(s) supplied to the electrode assembly 174 to generate the corrector electrostatic potential. This may be accomplished by regulating one or more electrical signals (e.g., voltages) that are delivered to the CPM system 100 and/or to the foil lens corrector 170.

For example, and as shown in FIG. 1, the controller 180 may include a booster tube voltage source 182 that is configured to apply the booster tube voltage to the booster tube 150. In particular, the booster tube voltage source 182 may be configured to convey a booster tube electrical signal 183 to the booster tube 150 that applies the booster tube voltage to the booster tube 150.

Additionally, or alternatively, the controller 180 may include one or more voltage sources that are configured to supply one or more electrical signals to the foil lens corrector 170, such as to apply one or more corresponding voltages to various components of the foil lens corrector 170 as described herein. In particular, and as shown in FIG. 1, the controller 180 may include a first electrode voltage source 184 that is configured to convey a first electrode electrical signal 185 to the electrode assembly 174 and/or a second electrode voltage source 186 that is configured to convey a second electrode electrical signal 187 to the electrode assembly 174.

As described herein, the controller 180 may be programmed and/or configured to control and/or vary the booster tube electrical signal 183, the first electrode electrical signal 185, and/or the second electrode electrical signal 187 to at least partially control operation of the foil lens corrector 170, such as to adjust an offsetting spherical aberration that the foil lens corrector 170 generates in the charged particle beam 124.

As shown in FIG. 1, the controller 180 can include a user interface 190 for receiving inputs from a human user and/or for recording and/or displaying information. In particular, the user interface 190 can include one or more input devices 192 and/or one or more output devices 194. The one or more input devices 192 can include and/or be any suitable devices for receiving inputs form a human user to at least partially direct operation of the CPM system 100, such as a keyboard, a mouse, a display, a touchscreen, etc. The one or more output devices 194 can include and/or be any suitable devices for conveying information to a human user, such as a display, a touchscreen, a physical storage drive, etc.

The controller 180 can include any of a variety of modules (e.g., hardware and/or software) for performing these and other functions. In some examples, the controller 180 is a single device that includes each of the constituent components described herein. In other examples, the controller 180 can refer to and/or encompass a collection of components that may be at least partially spatially separated. The controller 180 can be connected to any other suitable components of the CPM system 100 in any suitable manner, such as via one or more control lines and/or via wireless connections. As examples, such control lines can include and/or be physical signal conduits, such as wires, electrical buses, optical fibers, etc.

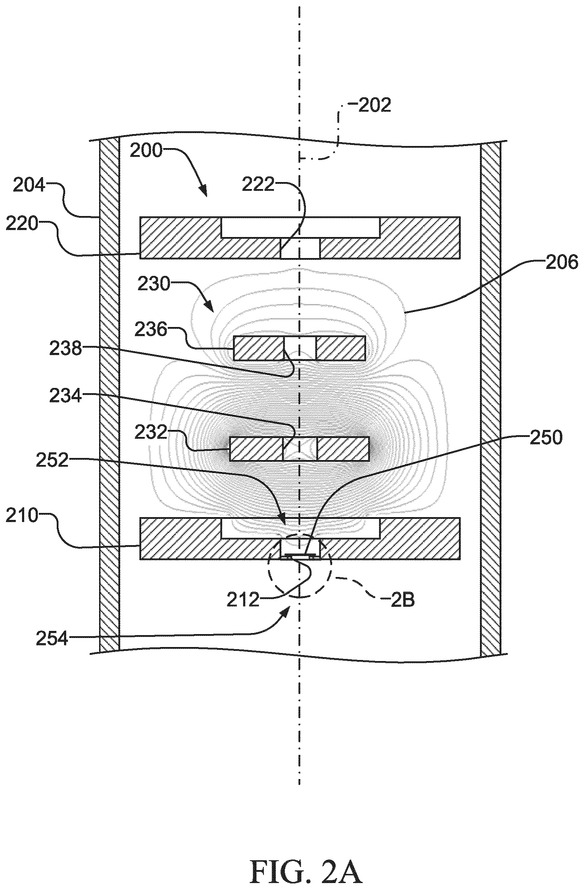

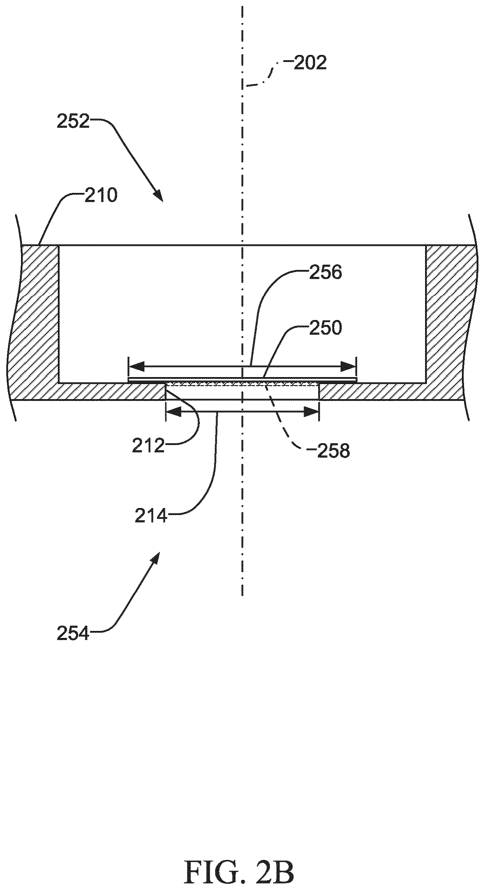

FIGS. 2A-2B illustrate components of an example of a foil lens corrector 200, which may represent an example of the foil lens corrector 170 of FIG. 1. In particular, FIG. 2B is a detail view of a region of FIG. 2A, as indicated by a dashed circle in FIG. 2A. The foil lens corrector 200 is illustrated as being positioned within a booster tube 204.

As shown in FIG. 2A, the foil lens corrector 200 includes a first shielding electrode 210 that supports a foil 250, a second shielding electrode 220, and an electrode assembly 230 positioned between the first shielding electrode 210 and the second shielding electrode 220. The electrode assembly 230 includes a first electrode 232 and a second electrode 236 positioned on a common side (i.e., the same side; in this example, an upstream side) of the foil 250. In this example, the foil 250 is positioned to extend across and/or cover a foil aperture 212 defined in the first shielding electrode 210.

In the present disclosure, references to structures, components, and/or features with names that are similar to or identical to those previously introduced in the context of a different figure may be understood as referring to more specific and/or alternative examples of the previously introduced structures, components, and/or features. Accordingly, such structures, components, and/or features may share any suitable characteristics, even if such characteristics are not specifically discussed with reference to each corresponding figure. As an example, the booster tube 204 of FIG. 2A may be described as representing an example of the booster tube 150 of FIG. 1 and may share any suitable characteristics, features, etc. with the booster tube 150.

FIG. 2A additionally illustrates an example of a corrector electrostatic potential 206 that may be generated by the electrode assembly 230. In particular, in the example of FIG. 2A, the corrector electrostatic potential 206 is represented by isopotential lines characterizing a configuration of the corrector electrostatic potential 206. The electrode assembly 230 may operate to generate the corrector electrostatic potential 206 through application of a first electrode voltage to the first electrode 232 (e.g., via the first electrode signal 185 of FIG. 1) and a second electrode voltage to the second electrode 236 (e.g., via the second electrode signal 187 of Fig. 1). The first electrode voltage and the second electrode voltage thus represent two independent degrees of freedom via which the corrector electrostatic potential 206 may be configured, as described in more detail below.

As shown in FIG. 2A, the electrode assembly 230 is configured to generate the corrector electrostatic potential 206 on a first side 252 of the foil 250. The foil lens corrector 200 further may be configured to confine the corrector electrostatic potential 206 to the first side 252 of the foil 250. For example, the foil 250 and/or the first shielding electrode 210 may serve to shield the corrector electrostatic potential 206 from extending to a second side 254 of the foil opposite the first side 252.

As a more specific example, the foil 250 may be configured to shield the corrector electrostatic potential such that a maximum magnitude of the corrector electrostatic potential 206 on the second side 254 of the foil 250 is at most 1% of a maximum magnitude of the corrector electrostatic potential 206 on the first side of the foil 250. In such examples, the maximum magnitude of the corrector electrostatic potential 206 on each side of the foil 250 may correspond to and/or refer to a magnitude at a location along the optical axis 202. In this manner, the foil 250 may be described as limiting and/or preventing the corrector electrostatic potential 206 from extending through the foil aperture 212, such as in a manner that otherwise could introduce aperture lensing effects.

In the example of FIG. 2A, the first side 252 of the foil 250 corresponds to the upstream side of the foil 250, while the second side 254 of the foil 250 corresponds to the downstream side of the foil 250. This is not required of all examples, however, and it also is within the scope of the present disclosure that the first side 252 of the foil 250 may correspond to the downstream side of the foil 250. In such examples, each of the first electrode 232 and the second electrode 236 may be positioned on the downstream side of the foil 250 such that the electrode assembly 230 generates the corrector electrostatic potential 206 on the downstream side of the foil. Accordingly, while the present disclosure generally relates to examples in which the electrode assembly 230 is positioned on the upstream side of the foil 250, it is to be understood that the opposite configuration also is within the scope of the present disclosure.

FIG. 2B illustrates a manner in which the foil 250 may be supported in the foil lens corrector 200. As shown in FIG. 2B, the first shielding electrode 210 can include a foil aperture 212 (e.g., a circular aperture) such that the foil 250 is coupled to the first shielding electrode 210 and covers (e.g., fully covers) the foil aperture 212.

As shown in FIG. 2B, the first shielding electrode 210 is configured such that the optical axis 202 (and thus a corresponding charged particle beam) extends through the foil aperture 212, and thus through the foil 250 covering the foil aperture 212. As shown in FIG. 2A, the second shielding electrode 220 can include a second aperture 222 that is axially aligned with the foil aperture 212 along the optical axis 202. Similarly, the first electrode 232 can have a first electrode aperture 234 and the second electrode 236 can have a second electrode aperture 238 that additionally are aligned along the optical axis 202. Any of the first shielding electrode 210, the second shielding electrode 220, the first electrode 232, and/or the second electrode 236 can extend fully around the optical axis 202.

As shown in FIG. 2B, the foil aperture 212 may be characterized by a foil aperture diameter 214, while the foil 250 may be characterized by a foil diameter 256. In the example of FIG. 2B, the foil diameter 256 is greater than the foil aperture diameter 214, such that the foil 250 completely covers the foil aperture 212. In an example in which the foil aperture 212 and/or the foil 250 is not perfectly circular, the foil aperture diameter 214 and/or the foil diameter 256 may correspond to any suitable linear dimension, such as a minimum diameter, a maximum diameter, an average diameter, etc. For example, to ensure that the foil 250 fully covers the foil aperture 212, the foil aperture diameter 214 may correspond to a maximum diameter of the foil aperture 212, while the foil diameter 256 may correspond to a minimum diameter of the foil.

In some examples, the foil aperture 212 may be described as effectively masking off a portion of the foil 250 (e.g., the portion of the foil 250 outside of the foil aperture 212) from contributing to an available area for charged particle beam transmission through the foil lens corrector 200. Accordingly, in various examples, the foil aperture diameter 214 also may be referred to as an effective foil diameter 214, which may be described as characterizing a region of the foil 250 through which the charged particle beam may pass. For example, the effective foil diameter 214 can correspond to and/or be equal to a maximum diameter of a charged particle beam that can be transmitted through the foil lens corrector 200. As discussed in more detail below, this diameter can be related to various other aspects of the operation of the CPM system, such as the beam current delivered to the specimen and/or the convergence angle of the charged particle beam. Accordingly, in many examples, it is desirable to configure the foil lens corrector 200 and/or foil 250 to exhibit as large an effective foil diameter 214 as may be practical.

The foil aperture diameter 214 and/or the effective foil diameter 214 may assume any of a variety of values, such as may correspond to a linear dimension of the foil 250 and/or a desired maximum diameter of a charged particle beam to be transmitted through the foil 250. As examples, the foil aperture diameter 214 and/or the effective foil diameter 214 may be at least 50 microns (µm), at least 100 µm, at least 200 µm, at least 300 µm, at least 500 µm, at most 700 µm, at most 400 µm, at most 250 µm, at most 150 µm, and/or at most 75 µm.

In some examples, the foil 250 may be freestanding across the foil aperture 212. Stated differently, in such examples, the foil 250 can extend across the foil aperture 212 with no direct support other than that provided by the structure at the periphery of the foil aperture 212. This is not required, however, and it also is within the scope of the present disclosure that the foil 250 may be supported by a foil support structure 258 that extends at least partially across the foil aperture. In such examples, the foil support structure 258 can include and/or be any of a variety of structures, examples of which include a grid (e.g., a TEM grid), a mesh, and/or a perforated structure. The foil support structure 258 may be directly coupled to and/or in direct contact with the foil 250, to the foil aperture 212, and/or to the first shielding electrode 210. The use of such a foil support structure 258 may enable the use of larger foils 250 to extend across larger foil aperture diameters 214, but also may result in increased scattering and/or decreased transmission of the charged particle beam through the foil aperture 212.

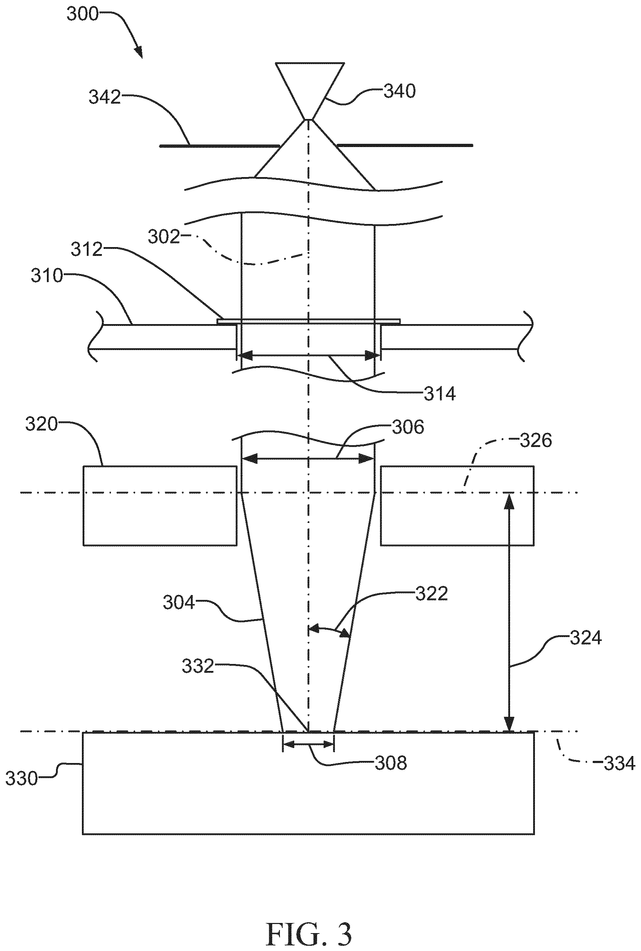

FIG. 3 illustrates a manner in which various dimensions of a foil lens corrector and/or of a CPM system including the foil lens corrector can affect various characteristics of a charged particle beam. Specifically, FIG. 3 schematically illustrates aspects of a CPM system 300 that includes a foil lens corrector 310 with a foil 312 positioned in line with an optical axis 302 along which a charged particle beam 304 travels. As shown in FIG. 3, the foil lens corrector 310 and/or the foil 312 defines an effective foil diameter 314, which thus represents a maximum diameter of the charged particle beam 304 that can pass through the foil lens corrector 310.

The CPM system 300 includes a charged particle beam source 340 that emits the charged particle beam 304 with a width that is at least partially limited by an aperture 342. The CPM system 300 additionally includes an objective lens assembly 320 that focuses the charged particle beam 304 to a focus location 332 within a specimen plane 334 associated with a specimen 330. The charged particle beam 304 may be characterized by a first beam diameter 306 upstream of and/or at the objective lens assembly 320. The objective lens assembly 320 can be configured to focus the charged particle beam 304 to a focused beam diameter 308 at the focus location 332.

In general, it may be desirable to operate the CPM system 300 such that the focused beam diameter 308 of the charged particle beam 304 is as small as possible, thereby maximizing the precision and/or resolution with which the CPM system can target a region of the specimen 330. The minimum achievable focused beam diameter 308, however, may be limited by various optical aberrations, as discussed herein. Accordingly, a beam pattern of the charged particle beam 304 in the specimen plane 334 may always have a nonzero focused beam diameter 308.

The beam pattern in the specimen plane 334 also may have a non-uniform intensity and/or may lack well defined edges. Accordingly, the focused beam diameter 308 may be characterized by the diameter *d*₅₀ of a circle oriented perpendicular to the optical axis 302 and centered on the focus location 332 that contains 50% of the charged particles of the charged particle beam. As used herein, a diameter *d*₅₀ defined in this manner also may be referred to as a characteristic beam diameter. The focused beam diameter 308 shown in FIG. 3 may represent such a characteristic beam diameter, and thus also may be referred to as a characteristic beam diameter 308.

The CPM system 300 may be configured such that the charged particle beam 304 has any suitable characteristic beam diameter 308. As examples, the characteristic beam diameter 308 may be at least 0.2 nm, at least 0.5 nm, at least 1 nm, at least 3 nm, at least 5 nm, at most 10 nm, at most 4 nm, at most 2 nm, at most 0.7 nm, at most 0.2 nm, 0.2-1 nm, 0.5-5 nm, and/or 1-10 nm.

The charged particle beam 304 also may be characterized by a beam convergence angle 322 (or "aperture angle"), which may be measured between the optical axis 302 and an outer extent of an envelope of the charged particle beam 304. As shown in FIG. 3, the beam convergence angle 322 can be geometrically related to the first beam diameter 306 and the focused beam diameter 308 via an objective focal length 324 as measured axially between the specimen plane 334 and a main objective plane 326 of the objective lens assembly 320. Specifically, as used herein, the main objective plane 326 of the objective lens assembly 320 refers to a plane spatially associated with the objective lens assembly 320 (e.g., at least partially within the objective lens assembly 320) from which the objective focal length 324 is measured.

In various examples, it is desirable to configure the CPM system 300 to exhibit a large aperture angle. For example, the minimum achievable focused beam diameter 308 may be limited by optical aberrations such as spherical and chromatic aberration, as well as by diffraction effects. In some examples, the degree of spherical aberration scales with the cube of the aperture angle and the degree of chromatic aberration scales linearly with the aperture angle, while diffraction effects are inversely proportional to the aperture angle. Accordingly, increasing the aperture angle can cause a decrease in undesirable diffraction effects at the expense of an increase in spherical and/or chromatic aberration effects. Such considerations thus may impose a practical limit to the maximum usable aperture angle. When using a foil lens corrector to correct spherical aberration and/or an energy selection apparatus to limit chromatic aberration, however, increasing the aperture angle may offer greater control over the minimum achievable focused beam diameter 308 by suppressing diffraction effects.

In practice, the objective lens assembly 320 may be operable to adjust the objective focal length 324, which in turn may yield variation in the focused beam diameter 308. For a given value of the objective focal length 324 (e.g., a value that minimizes the focused beam diameter 308 subject to optical aberrations), the beam convergence angle 322 may be increased via corresponding increase of the first beam diameter 306. The first beam diameter 306, in turn, may be limited by the effective foil diameter 314. Accordingly, it may be desirable to increase and/or maximize the effective foil diameter 314 in order to permit operation with a wide range of beam convergence angles 322.

Because the effective foil diameter 314 also is related to a maximum flux of the charged particle beam 304 through the foil lens corrector 310, a relatively large effective foil diameter 314 also may enable operation with a wide range of beam currents at the focus location 332. As examples, the CPM system 300 may be configured to direct the charged particle beam 304 to the specimen plane 334 with a beam current that is one or more of at least 10 picoamperes (pA), at least 30 pA, at least 50 pA, at least 100 pA, at least 300 pA, at least 500 pA, at least 1000 pA, at most 2000 pA, at most 700 pA, at most 400 pA, at most 200 pA, at most 70 pA, at most 40 pA, and/or at most 20 pA.

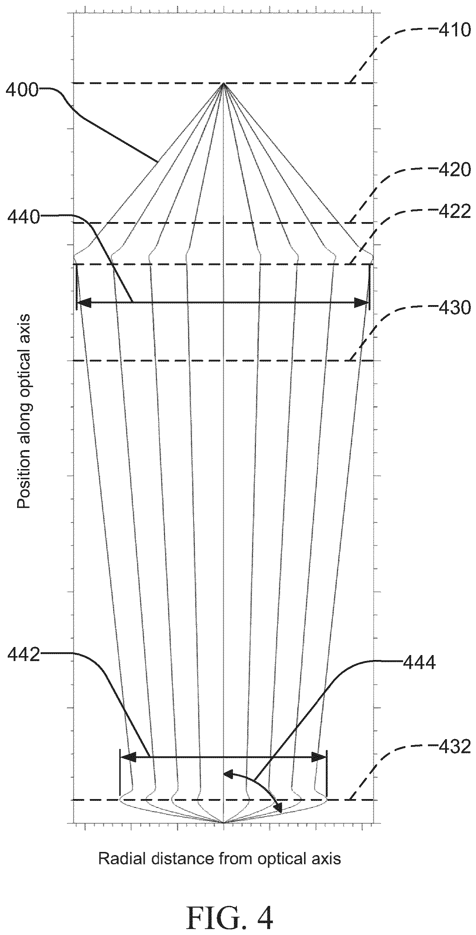

FIG. 4 is a less schematic illustration of a collection of ray trajectories 400 associated with a charged particle beam as the charged particle beam travels along the optical axis of a CPM system (such as the CPM system 100 of FIG. 1) with different scales in horizontal and vertical directions. In FIG. 4, the axial positions of various components of the CPM system are indicated with dashed horizontal lines. In particular, the line 410 represents the axial position of a charged particle beam source. The lines 420 and 422 represent upstream and downstream ends, respectively, of a foil lens corrector that operates upon the ray trajectories 400 to generate a negative spherical aberration in the charged particle beam. Specifically, the line 422 may represent the axial position of the foil of the foil lens corrector. The lines 430 and 432 represent upstream and downstream ends, respectively, of an objective lens assembly of the CPM system.

FIG. 4 additionally illustrates a manner in which a beam convergence angle 444 characterizing the charged particle beam downstream of the objective lens assembly may be related to characteristics of the foil lens corrector. Specifically, as shown in FIG. 4, the beam convergence angle 444 may be geometrically related to a beam width 442 of the charged particle beam as the charged particle beam exits the objective lens assembly. The beam width 442 in turn may be related to (e.g., proportional to) a beam width 440 of the charged particle beam as the charged particle beam exits the foil lens corrector. The beam width 440 may be limited by one or more dimensions associated with the foil lens corrector, such as the effective foil diameter discussed above with reference to FIGS. 2B and 3. Accordingly, configuring the foil lens corrector such that the foil and/or the foil aperture is as large as possible can correspondingly increase a maximum beam convergence angle that may be achieved with the CPM system.

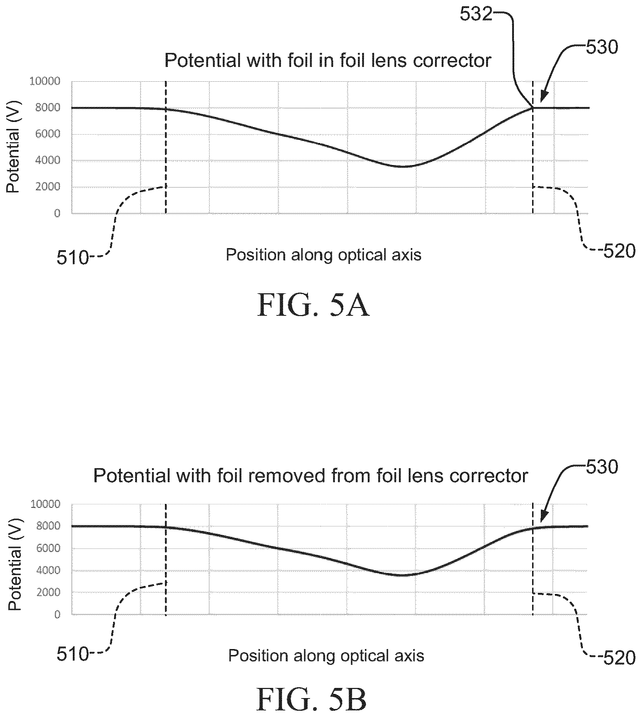

FIGS. 5A-5B illustrate a manner in which the foil of a foil lens corrector can operate to modify a spherical aberration of a charged particle beam passing through the foil lens corrector. In particular, FIG. 5A illustrates an axial electrostatic potential profile along an optical axis within a booster tube of a CPM system (e.g., the CPM system 100 of FIG. 1) in a region that includes a foil lens corrector with a foil in line with the optical axis. FIG. 5B illustrates the axial electrostatic potential in an example identical to that of FIG. 5A but with the foil removed from the foil lens corrector.

In FIGS. 5A-5B, the region corresponding to the axial position of the foil lens corrector is indicated by a pair of vertical dashed lines, with the line 510 corresponding to an upstream end of the foil lens corrector (e.g., the second shielding electrode 220 of FIG. 2), and with the line 520 corresponding to a downstream end of the foil lens corrector (e.g., the first shielding electrode 210 and/or the foil aperture 212 of FIG. 2). Specifically, FIGS. 5A-5B correspond to an example in which the foil is configured to be positioned at the downstream end of the foil lens corrector.

As shown in FIGS. 5A-5B, the electrostatic potential has a magnitude substantially equal to a booster tube voltage of 8000 V within the illustrated region other than the axial region corresponding to the location of the foil lens corrector, in which the corrector electrostatic potential serves to decrease the total electrostatic potential below 8000 V.

As shown in FIG. 5A, when the foil is installed in the foil lens corrector, the potential profile exhibits an abrupt knee 532, with the potential downstream of the foil being essentially equal to the booster tube voltage alone. This may be described as reflecting the property that the foil effectively shields the corrector electrostatic potential from extending downstream of the foil lens corrector such that total potential downstream of the foil lens corrector is that associated with the booster tube alone. By contrast, in the example of FIG. 5B, a portion of the corrector electrostatic potential extends into a region 530 downstream of the downstream end of the foil lens corrector, thereby decreasing the total electrostatic potential in this region to a value less than the booster tube voltage (e.g., the sum of the positive booster tube voltage and a negative corrector electrostatic potential).

The shape of the potential profile at the foil location shown in FIG. 5A may be related to the negative spherical aberration that may be generated by the foil lens corrector. For example, the potential profile shown in FIG. 5A may be described as exhibiting a substantial nonzero third derivative at the foil location 520, which in turn may be related to a third order spherical aberration coefficient associated with the foil lens corrector. Selective configuration of the potential profile upstream of the foil location 520, such as via selection of the first electrode voltage and the second electrode voltage, thus may enable adjustment of the third order spherical aberration coefficient and/or higher order spherical aberration coefficients.

The potential profile through the foil lens corrector may result in a lensing effect upon the charged particle beam in any of a variety of manners. For example, the foil lens corrector may be configured to operate as a convergent lens upon the charged particle beam. Alternatively, the foil lens corrector may be configured to operate as a divergent lens upon the charged particle beam.

The confinement of the corrector electrostatic potential to the region upstream of the foil also may offer practical benefits in the design of other components of the CPM system. For example, when the corrector electrostatic potential is effectively zero downstream of the foil lens corrector, it is possible to position additional optical and/or other components within the optical column and/or within the booster tube with negligible risk of such components interfering with and/or being affected by the corrector electrostatic potential.

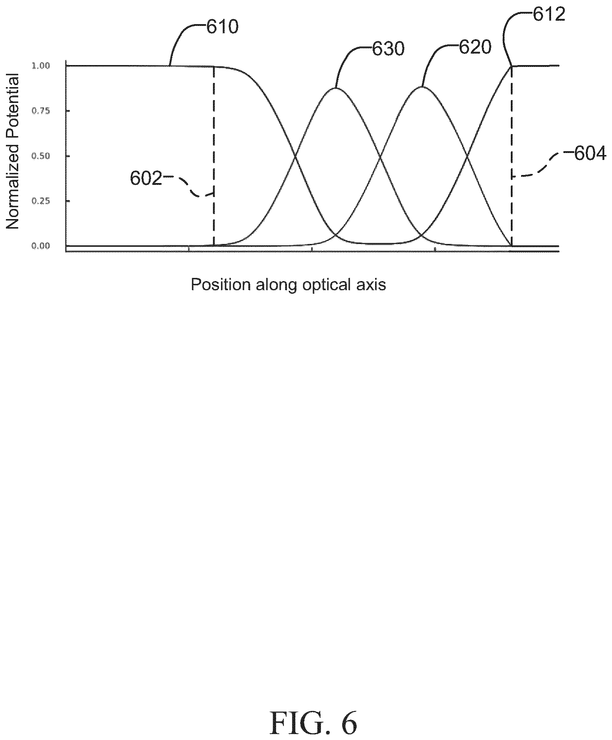

FIG. 6 illustrates an example set of axial electrostatic potential profiles associated with components of a CPM system (e.g., the CPM system 100 of FIG. 1) in a region that includes a foil lens corrector in line with the optical axis. Similar to FIGS. 5A-5B, the axial region depicted in FIG. 6 corresponds to a region within a booster tube that is maintained at a booster tube voltage, with a foil lens corrector being positioned in the region delimited by vertical dashed lines labeled 602 and 604. The axial position of the vertical dashed line 604 represents the axial position of the foil of the foil lens corrector.

The potential profile labeled 610 in FIG. 6 represents a profile of the potential generated by the booster tube, normalized to the value of the booster tube voltage. Thus, the potential profile 610 has a value of 1 outside of the foil lens corrector. Within the foil lens corrector, the potential profile 610 is diminished, such as due to one or more elements of the foil lens corrector at least partially shielding the optical axis from the booster tube potential. For example, with reference to FIG 2A, the first electrode 232 and/or the second electrode 236 can operate to shield the optical axis 202 from the booster tube potential. Similar to FIG. 5A, the potential profile 610 exhibits an abrupt knee 612 at the foil location 604, again corresponding to the shielding behavior of the foil.

The potential profiles labeled 620 and 630 in FIG. 6 represent profiles of the potential generated by the first electrode and the second electrode, respectively, of the foil lens corrector. Each of the potential profile 620 and the potential profile 630 also is normalized to the value of the booster tube voltage. In this manner, FIG. 6 may be described as representing the separate potential components that combine to form a total potential profile such as that shown in FIG. 5A. Stated differently, FIG. 5A may be described as representing the sum of the potential profiles presented in FIG. 6 as the normalized profiles 610, 620, and 630. Stated differently, while FIG. 6 presents the potential profiles 610, 620, and 630 in normalized units, it is to be understood that the numerical values depicted in FIG. 5A represent the sum of the corresponding potentials without (e.g., prior to) such normalization.

The potential profiles 620 and 630 of FIG. 6 may be adjusted independently of one another via selection of the corresponding first electrode voltage and second electrode voltage. In this manner, the relative and absolute magnitudes of the potential profiles 620 and 630 may be adjusted to adjust the lensing characteristics of the foil lens corrector upon a charged particle beam that travels along the optical axis.

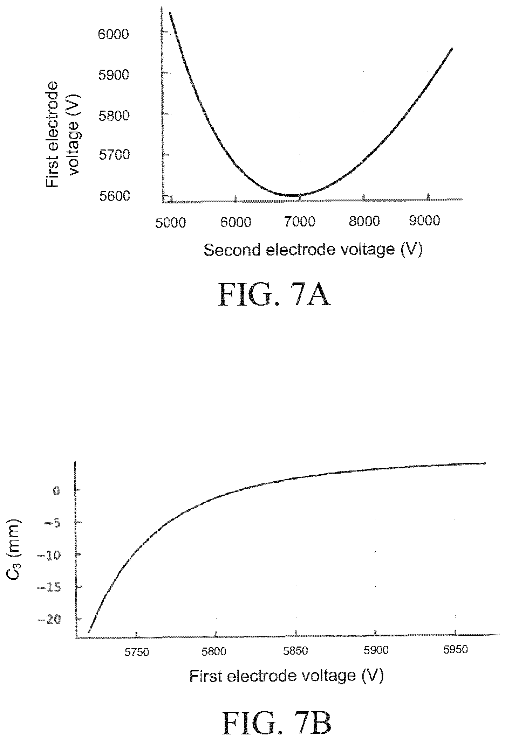

FIGS. 7A-7D illustrate various manners in which characteristics of the charged particle beam associated with a CPM system (e.g., the CPM system 100 of FIG. 1) may depend upon the first electrode voltage and/or the second electrode voltage associated with a foil lens corrector of the CPM system. In particular, the first electrode voltage and the second electrode voltage discussed herein with reference to FIGS. 7A-7D may correspond to the voltages applied to the first electrode and the second electrode, respectively, of the electrode assembly of any suitable foil lens corrector disclosed herein. Each of FIGS. 7A-7C corresponds to a common CPM configuration in which the CPM system focuses the charged particle beam to the focus location with a landing energy of 3 keV and with a beam current of approximately 80 pA.

FIG. 7A illustrates an example of a steering curve by which the first electrode voltage and the second electrode voltage may be varied while the foil lens corrector produces a constant offsetting spherical aberration in the charged particle beam. In particular, the constant offsetting spherical aberration generated by the foil lens corrector may be that which yields a spherical aberration at the specimen plane that is characterized by a third order spherical aberration coefficient of zero. In this manner, for a given (constant) value of the third order spherical aberration coefficient *C*₃ characterizing the offsetting spherical aberration generated by the foil lens corrector, and at a given value of the second electrode voltage, FIG. 7A depicts the value of the first electrode voltage that will produce the given value of *C*₃, such as to negate the spherical aberration at the specimen plane. FIG. 7A thus represents examples of combinations of the first electrode voltage and the second electrode voltage that can produce a selected value of *C*₃.

FIG. 7B illustrates an example of a relationship between the third order spherical aberration coefficient *C*₃ and the first electrode voltage for a constant second electrode voltage. In particular, in the example of FIG. 7B, the second electrode voltage is maintained at 7200 V. Additionally, in this example, the coefficient *C*₃ represents the total third order spherical aberration of the charged particle beam at a focus location and/or in a specimen plane. Thus, for a given predetermined operational value of the second electrode voltage, a plot such as that shown in FIG. 7B may indicate the value of the first electrode voltage that will bring *C*₃ to a desired (e.g., sufficiently small) value. In the example of FIG. 7B, the total third order spherical aberration of the charged particle beam reaches a value of zero at a first electrode voltage of approximately 5820 V.

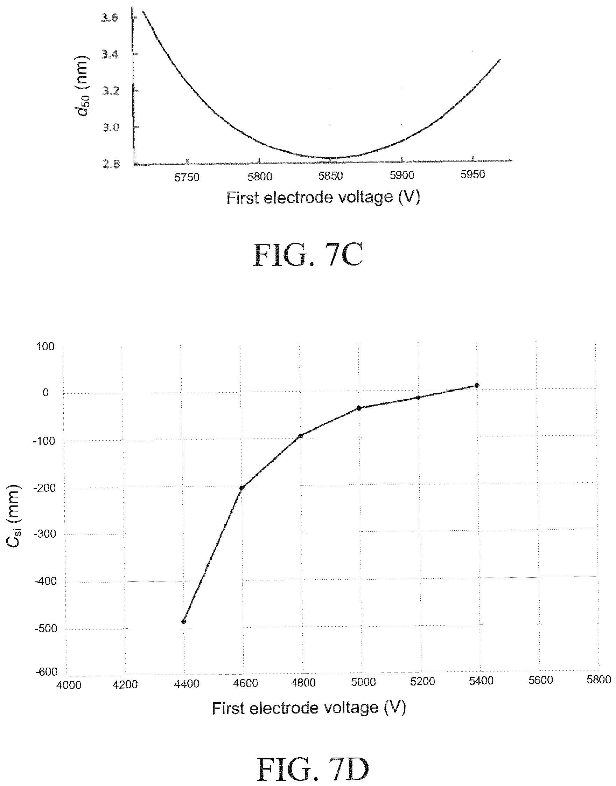

FIG. 7C similarly illustrates an example of the dependence of a characteristic beam diameter *d*₅₀ of a charged particle beam on the first electrode voltage, for a given value of the second electrode voltage. In particular, in the example of FIG. 7C, the second electrode voltage is maintained at 7200 V. As shown in FIG. 7C, the characteristic beam diameter reaches a minimum value at a first electrode voltage of approximately 5850 V.

The discrepancy between the value of the first electrode voltage that minimizes *C*₃ (FIG. 7B) and the value of the first electrode voltage that minimizes *d*₅₀ (FIG. 7C) may be at least partially attributed to the fact that the minimum attainable beam diameter depends not only on the third order spherical aberration but also on chromatic aberrations and higher order spherical aberrations. Other factors that can limit the minimum attainable beam diameter include diffraction effects, a size of the charged particle source, etc.

FIG. 7D illustrates an example of a relationship between the total spherical aberration *C*ₛᵢ of a charged particle beam focused to a focus location and the first electrode voltage. FIG. 7D corresponds to an example in which the CPM system focuses the charged particle beam to the focus location with a landing energy of 10 keV and with a beam current of 80 pA, and in which the second electrode voltage is 5000 V. Under these conditions, and as shown in FIG. 7D, the total spherical aberration *C*ₛᵢ reaches a value of zero at a first electrode voltage of approximately 5350 V.

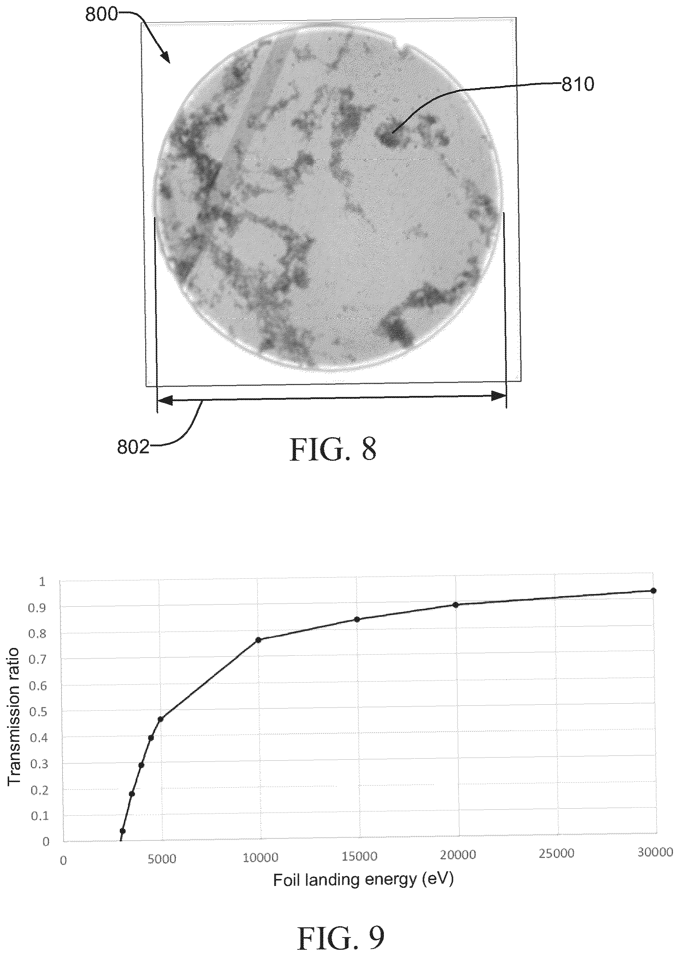

As discussed above, in various examples, the foil of a foil lens corrector according to the present disclosure includes and/or is a foil of graphene. FIG. 8 illustrates an example of a foil 800 in the form of a graphene foil characterized by a foil diameter 802. The foil diameter 802 shown in FIG. 8 may correspond to the diameter of the foil 800 itself, and/or may correspond to an effective foil diameter as discussed above with reference to FIG. 2B.

In the example of FIG. 8, the foil 800 also includes various surface contaminants 810. To minimize interactions between the foil 800 and the charged particle beam, it may be desirable to minimize the incidence of contaminants 810 on the foil 800 during preparation of the foil 800 and/or to remove such contaminants 810 during operative use of the foil lens corrector, as described in more detail below.

As discussed above, using a foil of graphene may offer a desirably high degree of transmission of the charged particle beam through the foil within an operative range of charged particle beam energies. For example, FIG. 9 illustrates a relationship between the transmission ratio through a foil of three-layer graphene as a function of the foil landing energy with which a charged particle beam (e.g., of electrons) is incident upon the foil.

With reference to the CPM system 100 of FIG. 1, the foil landing energy may be at least partially based on the booster tube potential applied to the booster tube 150. Specifically, the foil landing energy may be at least substantially equal to a sum of the booster tube potential and an energy with which the charged particle beam is generated by a beam emitter of the CPM system. FIG. 9 thus illustrates a beneficial aspect of using a foil lens corrector in conjunction with a booster tube, as the increased energy of the charged particle beam results in an effectively smaller cross section for interaction with the material of the foil. As shown in FIG. 9, a graphene foil can yield a transmission ratio of approximately 70% when the foil landing energy (e.g., the sum of the booster tube potential and the potential of the charged particle source) is approximately 8000 V.

This is not required of all examples, however, and it also is within the scope of the present disclosure that the foil landing energy and the transmission ratio each may assume any of a variety of values. As examples, the CPM system and/or the foil lens corrector may be configured such that the transmission ratio corresponding to a given operative foil landing energy is at least 5%, at least 10%, at least 20%, at least 30%, at least 50%, at least 70%, at least 80%, at most 95%, at most 75%, at most 60%, at most 40%, at most 25%, at most 15%, and/or at most 7%. Additionally, or alternatively, the CPM system may be configured such that the operative foil landing energy is at least 5 kiloelectronvolts (keV), at least 7 keV, at least 10 keV, at least 15 keV, at least 20 keV, at least 30 keV, at least 50 keV, at 70 keV, at most 80 keV, at most 60 keV, at most 40 keV, at most 25 keV, at most 17 keV, at most 12 keV, at most 8 keV, at most 6 keV, 5-8 keV, 7-12 keV, 5-15 keV, 5-20 keV, 5-30 keV, 5-40 keV, 5-60 keV, and/or 5-80 keV.

In general, the transmission ratio characterizing a graphene foil also may depend upon the beam current of the charged particle beam; however, for beam currents in the pA and nA ranges, the transmission ratio may be described as effectively depending only upon the incident charged particle energy. For a given foil landing energy, the transmission ratio characterizing transmission of a charged particle beam through the foil may increase as the thickness (e.g., number of layers) of the foil decreases. Constructing the foil lens corrector with few layers (e.g., one layer) of graphene can introduce practical challenges, as such graphene foils may be correspondingly difficult to prepare and/or handle.

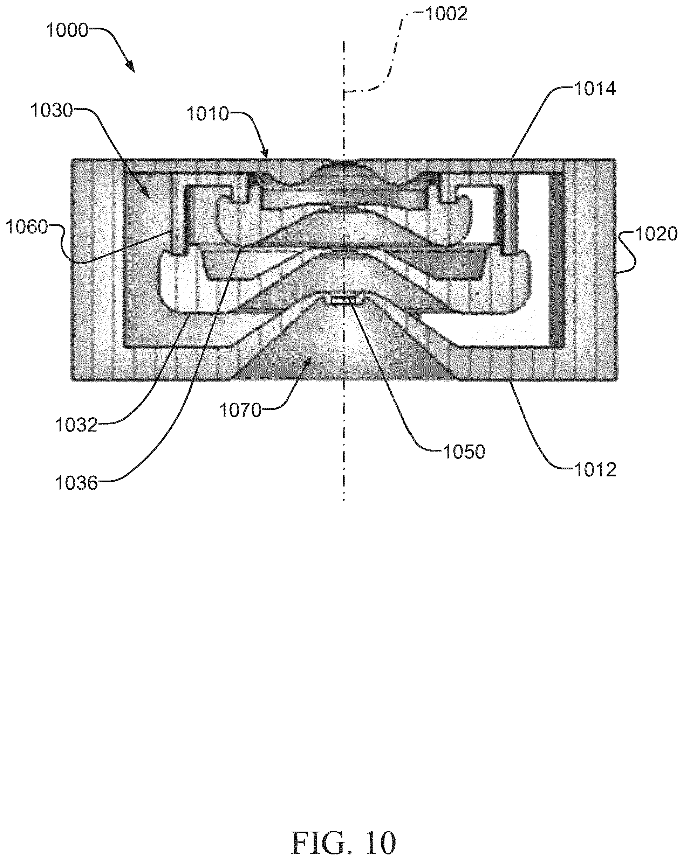

FIG. 10 illustrates another example of a foil lens corrector 1000 according to the present disclosure, which also can represent an example of the foil lens corrector 170 of FIG. 1. Similar to the foil lens corrector 200 of FIG. 2, the foil lens corrector 1000 includes a foil 1050 and an electrode assembly 1030 that includes a first electrode 1032 and a second electrode 1036 positioned on a common side (i.e., the same side) of the foil 1050. In the example of FIG. 10, the foil lens corrector 1000 includes a corrector housing 1010 that supports the foil 1050 and/or at least a portion of the electrode assembly 1030. In particular, in the example of FIG. 10, the first electrode 1032 and the second electrode 1036 are contained within the corrector housing 1010.

Similar to the example of FIG. 2, the foil lens corrector 1000 of FIG. 10 may be described as including a first shielding electrode 1012 that supports the foil 1050 and second shielding electrode 1014 such that the electrode assembly 1030 is positioned between the first shielding electrode 1012 and the second shielding electrode 1014. In the example of FIG. 10, the corrector housing 1010 may be described as including the first shielding electrode 1012 and the second shielding electrode 1014, as well as a housing body 1020 that extends between the first shielding electrode 1012 and the second shielding electrode 1014. In the example of FIG. 10, the housing body 1020 takes the form of a substantially cylindrical wall connecting the first shielding electrode 1012 and the second shielding electrode 1014. As discussed in more detail below, the corrector housing 1010 and/or the first shielding electrode 1012 includes a housing indentation 1070 that extends inward toward the electrode assembly 1030.

The housing body 1020 can be directly coupled to and/or in direct contact with each of the first shielding electrode 1012 and the second shielding electrode 1014, such as to electrically couple the first shielding electrode 1012 and the second shielding electrode 1014 to one another. Additionally, or alternatively, the housing body 1020 may be monolithic with and/or integrally formed with the first shielding electrode 1012 and/or the second shielding electrode 1014.

In examples in which the first shielding electrode 1012, the second shielding electrode 1014, and the housing body 1020 are electrically coupled to one another, such components may be described as representing respective portions of a single electrode structure that may be maintained at a selected potential during operative use of the foil lens corrector 1000. For example, an entirety of the corrector housing 1010 including the first shielding electrode 1012, the second shielding electrode 1014, and the housing body 1020 may be configured to be maintained at the booster tube voltage during operative use of a CPM system that includes the foil lens corrector 1000.

In the example of FIG. 10, the corrector housing 1010 can be configured to restrict the corrector electrostatic potential from extending beyond the corrector housing 1010. For example, the first shielding electrode 1012, the second shielding electrode 1014, and/or the housing body 1020 may be configured to shape the corrector electrostatic potential within the corrector housing 1010 and/or to at least partially confine the corrector electrostatic potential (e.g., radially) within the corrector housing 1010.

In order to maintain the first electrode 1032 and the second electrode 1036 at potentials other than that of the corrector housing 1010, the first electrode 1032 and the second electrode 1036 may be electrically insulated from the corrector housing 1010. In particular, in the example of FIG. 10, the foil lens corrector 1000 includes an insulating support 1060 that supports the first electrode 1032 and the second electrode 1036 relative to the corrector housing 1010. The insulating support 1060 may be formed of a material with a suitably low electrical conductivity to electrically insulate the first electrode 1032 and the second electrode 1036 from the corrector housing 1010.

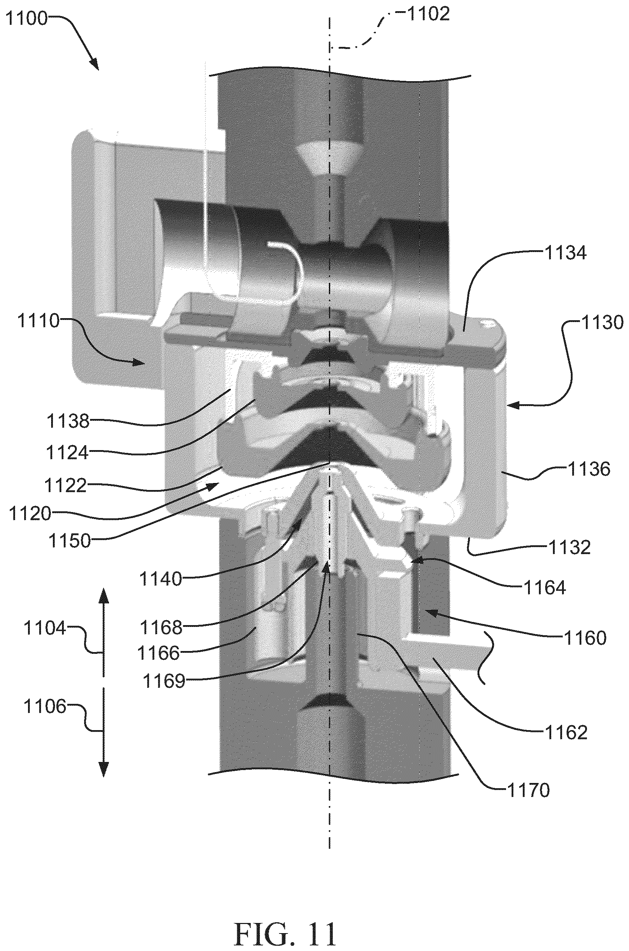

FIG. 11 illustrates a portion of a CPM system 1100 that includes a foil lens corrector 1110 according to the present disclosure. The foil lens corrector 1110 of FIG. 11 may be at least substantially identical to the foil lens corrector 1000 of FIG. 10, and/or may be described as representing an example of the foil lens corrector 170 of FIG. 1. With reference to the upstream direction 1104 and the downstream direction 1106 labeled in FIG. 11, the foil lens corrector 1110 is configured such that a foil 1150 is positioned downstream of a first electrode 1122 and a second electrode 1124 of an electrode assembly 1120. Similar to FIG. 10, the foil lens corrector 1110 of FIG. 11 additionally includes a corrector housing 1130 with a first shielding electrode 1132, a second shielding electrode 1134, and a housing body 1136, as well as an insulating support 1138 that electrically insulates the first electrode 1122 and the second electrode 1124 from the corrector housing 1130.

In the example of FIG. 11, the CPM system 1100 and/or the foil lens corrector 1110 additionally includes a corrector heater 1160 that is configured to heat the foil 1150 during operative use of the CPM system 1100 and/or during operative use of the foil lens corrector 1110. The corrector heater 1160 includes a heating element 1162 configured to receive an electrical current, such as for generating resistive heat energy, and a heater body 1164 configured to convey heat energy to the foil 1150. The heater body 1164 can include an electrically insulating portion 1166 and an electrically conductive portion 1168. As shown in FIG. 11, the heating element 1162, the heater body 1164, and/or the electrically conductive portion 1168 may define at least a portion of a heater conduit 1169 configured to allow a charged particle beam to pass through the corrector heater 1160 and/or the heater body 1164 along the optical axis 1102.

The corrector heater 1160 may be configured to heat the foil 1150 in a manner to reduce and/or restrict formation of contaminants on the foil 1150 that may adversely interfere with transmission of the charged particle beam. For example, during operative use of the CPM system 1100, the charged particle beam can crack various carbohydrate species that may be present in foil imperfections and/or in residual atmospheres, which subsequently may adhere to the foil 1150. By heating the foil 1150 to a temperature of approximately 200 °C, such contaminants may be prevented from adhering to the foil 1150 and/or may be expelled from the foil 1150.

In various examples, the electrically insulating portion 1166 of the heater body 1164 is formed of a material that is thermally conductive and electrically insulating, such as aluminum nitride. In this manner, the electrically insulating portion 1166 may operate to electrically isolate the heating element 1162 from the foil 1150 and/or the corrector housing 1130. The heating element 1162 thus may be spaced apart from the foil 1150 and the corrector housing 1130. Such a configuration may enable efficient heat transfer to the foil 1150 (e.g., via conductive heat transfer) without requiring that the heating element 1162 be able to withstand the high voltages at which the foil 1150 and/or the corrector housing 1130 may be maintained.

In various examples, the electrically conductive portion 1168 of the heater body 1164 is formed of a material that is both electrically and thermally conductive, such as molybdenum. As shown in FIG. 11, the electrically conductive portion 1168 may include and/or be a tubular element that contacts the foil 1150 and/or the corrector housing 1130 to support conductive thermal heating of the foil 1150. The electrically conductive portion 1168 thus may be maintained at the same electrical potential as the foil 1150 and/or the corrector housing 1130, such as the booster tube potential. Configuring the electrically conductive portion 1168 to be electrically conductive can beneficially allow for the charged particle beam to travel through the heater conduit 1169 without charging the electrically conductive portion 1168.

In some examples, and as shown in FIG. 11, the CPM system 1100 includes a ferromagnetic conduit 1170 positioned downstream of at least a portion of the heater body 1164 (e.g., downstream of the heater conduit 1169). When present, the ferromagnetic conduit 1170 can operate to at least partially shield the charged particle beam from electromagnetic interference associated with and/or generated by the corrector heater 1160.

As discussed above, confinement of the corrector electrostatic potential generated by the electrode assembly 1120 to a region upstream of the foil 1150 can ensure that the lensing operation of the foil lens corrector 1110 is not adversely affected by the introduction of the corrector heater 1160. As shown in FIG. 11, the corrector heater 1160 thus may be positioned in close proximity to the foil 1150. In particular, in this example, the first shielding electrode 1132 of the corrector housing 1130 defines a housing indentation 1140 that extends toward the electrode assembly 1120 and that receives at least a portion of the corrector heater 1160 and/or of the heater body 1164 (e.g., the electrically conductive portion 1168).

The heater body 1164 may be thermally coupled to the heating element 1162 and/or to the foil 1150 in any suitable manner. For example, and as shown in FIG. 11, the electrically insulating portion 1166 of the heater body 1164 may be directly coupled to and/or in direct contact with the heating element 1162, while the electrically conductive portion 1168 of the heater body 1164 may be directly coupled to and/or in direct contact with the electrically insulating portion 1166 and the foil 1150 (and/or a region of the first shielding electrode 1132 near the foil 1150). In such examples, the corrector heater 1160 may be configured to heat the foil 1150 predominantly via conductive heat transfer. In other examples, the heater body 1164 may be spaced apart from the heating element 1162 and/or the corrector housing 1130. In such examples, the corrector heater 1160 may be configured to heat the foil 1150 at least partially via radiative heat transfer.

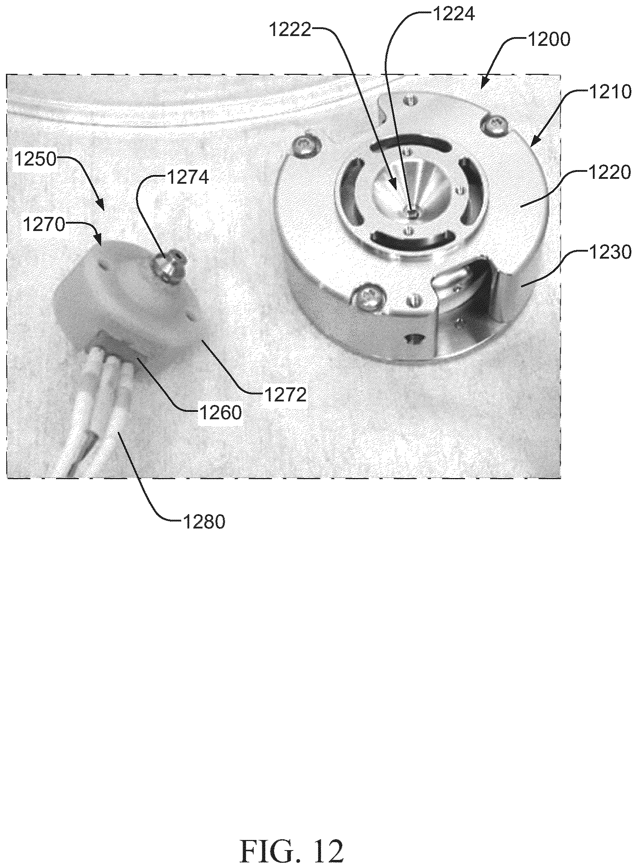

FIG. 12 illustrates examples of a foil lens corrector 1200 and a corrector heater 1250 in a disassembled configuration. The foil lens corrector 1200 and the corrector heater 1250 of FIG. 12 may be at least substantially identical to the foil lens corrector 1110 and the corrector heater 1160, respectively, of FIG. 11. For example, as shown in FIG. 12, the foil lens corrector 1200 includes a corrector housing 1210 with a first shielding electrode 1220 and a housing body 1230 extending from the first shielding electrode 1220. The first shielding electrode 1220 defines a housing indentation 1222 configured to receive a portion of the corrector heater 1250. The corrector heater 1250 includes a heating element 1260 and a heater body 1270. The heater body 1270 includes an electrically insulating portion 1272 and an electrically conductive portion 1274. Additionally shown in FIG. 12 are a plurality of electrical leads 1280 that may be configured to supply electric current to the heating element 1260 to generate the heat energy.

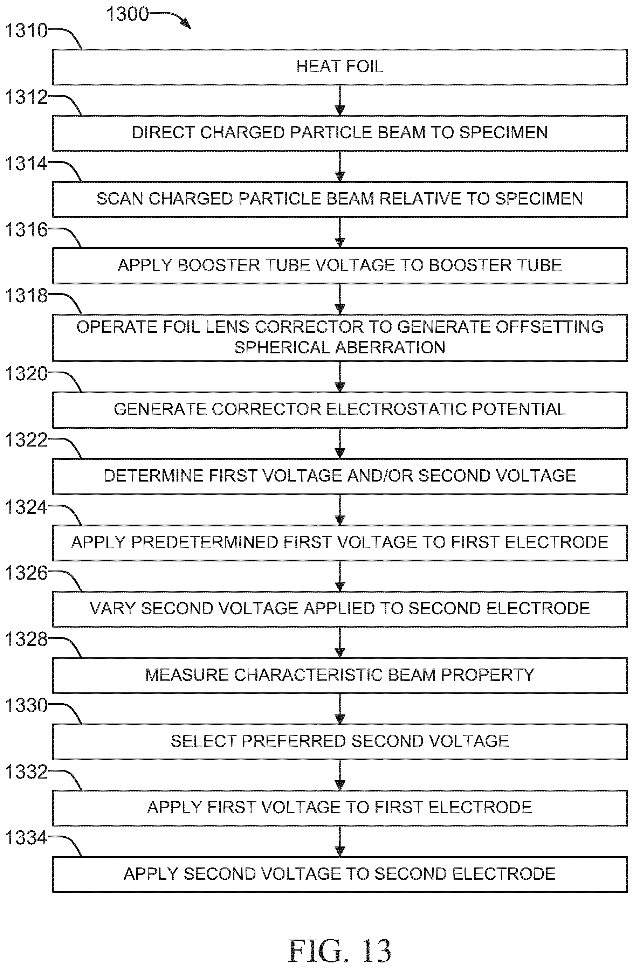

FIG. 13 is a flow chart depicting examples of a method 1300 of operating a foil lens corrector (e.g., the foil lens corrector 170 of FIG. 1, the foil lens corrector 200 of FIGS. 2A-2B, the foil lens corrector 310 of FIG. 3, the foil lens corrector 1000 of FIG. 10, and/or the foil lens corrector 1110 of FIG. 11) and/or a CPM system including such a foil lens corrector (e.g., the CPM system 100 of FIG. 1 and/or the CPM system 1100 of FIG. 11). In the following discussion, various components are described in the context of the method 1300 with terms that correspond to components illustrated in FIGS. 1-12 and discussed above. Such components described herein with reference to the method 1300 thus may be understood as corresponding to and/or as representing the similarly named components described above with reference to FIGS. 1-12. As described in more detail below, any suitable portions of the method 1300 can be performed with a controller of the CPM system, such as the controller 180 of FIG. 1.

As shown in FIG. 13, the method 1300 includes directing, at 1312, a charged particle beam along an optical axis to a specimen positioned in a specimen plane and operating, at 1318, a foil lens corrector positioned along the optical axis to generate an offsetting spherical aberration. In particular, the operating the foil lens corrector at 1318 can include operating such that the offsetting spherical aberration is opposite in sign and at least substantially equal in magnitude to a spherical aberration component of the charged particle beam at the specimen plane when the foil lens corrector is omitted from the CPM system. As discussed herein the offsetting spherical aberration may be characterized by a negative spherical aberration coefficient or a positive spherical aberration coefficient.

As discussed herein, the foil lens corrector can include a foil through which the charged particle beam is at least partially transmitted. The operating the foil lens corrector at 1318 can include directing the charged particle beam to the foil such that the charged particle beam is incident upon the foil with any of a variety of foil landing energies. As examples, the foil landing energy may be at least 5 kiloelectronvolts (keV), at least 7 keV, at least 10 keV, at least 15 keV, at least 20 keV, at least 30 keV, at least 50 keV, at 70 keV, at most 80 keV, at most 60 keV, at most 40 keV, at most 25 keV, at most 17 keV, at most 12 keV, at most 8 keV, at most 6 keV, 5-8 keV, 7-12 keV, 5-15 keV, 5-20 keV, 5-30 keV, 5-40 keV, 5-60 keV, and/or 5-80 keV.

Additionally, the operating the foil lens corrector at 1318 can include transmitting the charged particle beam through the foil with any of a variety of transmission ratios, examples of which include at least at least 5%, at least 10%, at least 20%, 30%, at least 50%, at least 70%, at least 80%, at most 95%, at most 75%, at most 60%, at most 40%, at most 25%, at most 15%, and/or at most 7%. As a more specific example, the operating the foil lens corrector at 1318 may include directing such that the charged particle beam is incident upon the foil with a foil landing energy that is at least 5 keV and at most 80 keV and the charged particle beam is transmitted through the foil with a transmission ratio that is at least 20%.

As discussed herein, the CPM system can include a booster tube configured to accelerate the charged particle beam within at least a portion of the CPM system. Accordingly, and as shown in FIG. 13, the method 1300 may include applying, at 1316, a booster tube voltage to the booster tube. The applying the booster tube voltage at 1316 can include applying such that the booster tube voltage is any of a variety of voltages, examples of which include at least 5 kV, at least 7 kV, at least 10 kV, at most 12 kV, at most 8 kV, at most 6 kV, 5-8 kV, 7-12 kV, and/or 5-12 kV.

In various examples, the operating the foil lens corrector at 1318 include generating, at 1320 and with an electrode assembly of the foil lens corrector, a corrector electrostatic potential that operates to generate at least a portion of the offsetting spherical aberration in the charged particle beam. The generating the corrector electrostatic potential at 1320 can include generating such that the corrector electrostatic potential is at least substantially constrained to a first side of the foil. In various examples, the generating the corrector electrostatic potential at 1320 includes generating the corrector electrostatic potential only on a first side of the foil.

In various examples, the generating the corrector electrostatic potential at 1320 includes applying, at 1332, a first voltage to a first electrode of the electrode assembly and/or applying, at 1334, a second voltage to a second electrode of the electrode assembly. While the present disclosure generally relates to examples in which the electrode assembly includes the first electrode and the second electrode, this is not required of all examples, and it also is within the scope of the present disclosure that the electrode assembly can include a single electrode. Accordingly, in some cases, references herein to the first electrode and/or the corresponding first voltage may be understood as referring to the sole electrode of the electrode assembly.

As discussed herein, the first electrode voltage and the second electrode voltage may be understood as representing respective independent degrees of freedom with which operation of the foil lens corrector may be configured, such as to produce a desired offsetting spherical aberration. Accordingly, in some examples, and as shown in FIG. 13, the method 1300 includes determining, at 1322, the first voltage and/or the second voltage, such as to identify a combination of the first voltage and the second voltage that will produce the desired offsetting spherical aberration. The determining the first voltage and/or the second voltage at 1322 may be performed prior to the applying the first voltage at 1332 and/or the applying the second voltage at 1334.

As a more specific example, the method 1300 and/or the determining the voltage(s) at 1322 can include applying, at 1324, a predetermined first voltage to the first electrode and determining a corresponding second voltage that yields a desired property of the charged particle beam. In such examples, the method 1300 can include, with the first electrode maintained at the predetermined first voltage, varying, at 1326, the second voltage that is applied to the second electrode. The method 1300 also can include measuring, at 1328, a characteristic beam property of the charged particle beam corresponding to each second voltage as the second voltage is varied and selecting, at 1330, a preferred second voltage corresponding to a preferred value of the characteristic beam property. The characteristic beam property can include and/or be any of a variety of measurable properties of the charged particle beam, such as a characteristic beam diameter of the charged particle beam at the specimen plane and/or a spherical aberration of the charged particle beam at the specimen plane. In such examples, the applying the first voltage at 1332 can include applying the predetermined first voltage to the first electrode and applying the preferred second voltage to the second electrode.

In other examples, the determining the first voltage and/or the second voltage at 1322 may be performed in an opposite manner, such as by fixing the second voltage to a predetermined value and varying the first voltage to identify a preferred value of the first voltage.

In some examples, and as shown in FIG. 13, the method 1300 additionally includes heating, at 1310, the foil of the foil lens corrector with a corrector heater. As discussed herein, heating the foil with a corrector heater can facilitate preventing contaminants from adhering to the foil and/or removing such contaminants from the foil. In some examples, the heating the foil at 1310 includes heating the foil to a temperature that is approximately 200 °C. In some examples, the heating the foil at 1310 includes conveying thermal energy from a heating element of the corrector heater to the foil via a heater body that electrically isolates the heating element from the foil.

The heating the foil at 1310 may be performed at any suitable point during operation of the CPM system and/or of the foil lens corrector. For example, the heating the foil at 1310 may include heating the foil at least partially concurrently with the directing the charged particle beam at 1312. Additionally, or alternatively, the heating the foil at 1310 may be performed prior to the directing the charged particle beam at 1312. For example, the heating the foil at 1310 may include heating the foil to an elevated and/or predetermined initial temperature (e.g., approximately 200 °C) prior to directing the charged particle beam through the foil. Such a procedure may serve to protect the foil from damage that otherwise may occur due to interaction between the charged particle beam and contaminants on the foil.

The directing the charged particle beam at 1312 may include directing the charged particle beam to any suitable portion, or portions, of the specimen. For example, and as shown in FIG. 13, the directing the charged particle beam at 1312 may include scanning, at 1314 and with one or more scanning deflectors of the CPM system, the charged particle beam (and/or a focus location thereof) relative to the specimen. Scanning the charged particle beam relative to the specimen in this manner may serve to probe an area of the surface of the specimen, such as to produce a micrograph of the specimen. In various examples, the scanning the charged particle beam at 1314 may include scanning the charged particle beam across a region with a linear dimension (e.g., a field of view) that is at least 50 nm, at least 100 nm, at least 200 nm, at least 300 nm, at least 500 nm, at least 1000 nm, at most 1200 nm, at most 700 nm, at most 250 nm, at most 150 nm, and/or at most 75 nm.

The directing the charged particle beam at 1312 also may include directing such that the charged particle beam has any of a variety of beam characteristics at the specimen plane. As examples, the directing the charged particle beam at 1312 may include focusing the charged particle beam in a specimen plane to a spot with a characteristic diameter that is at least 0.2 nm, at least 0.5 nm, at least 1 nm, at least 3 nm, at least 5 nm, at most 10 nm, at most 4 nm, at most 2 nm, at most 0.7 nm, at most 0.2 nm, 0.2-1 nm, 0.5-5 nm, and/or 1-10 nm. Additionally, or alternatively, the directing the charged particle beam at 1312 may include directing such that the charged particle beam has a spherical aberration in the specimen plane that is characterized by a third order spherical aberration coefficient with a magnitude that is one or more of at most 5 mm, at most 3 mm, at most 1 mm, at most 0.5 mm, or 0 mm.

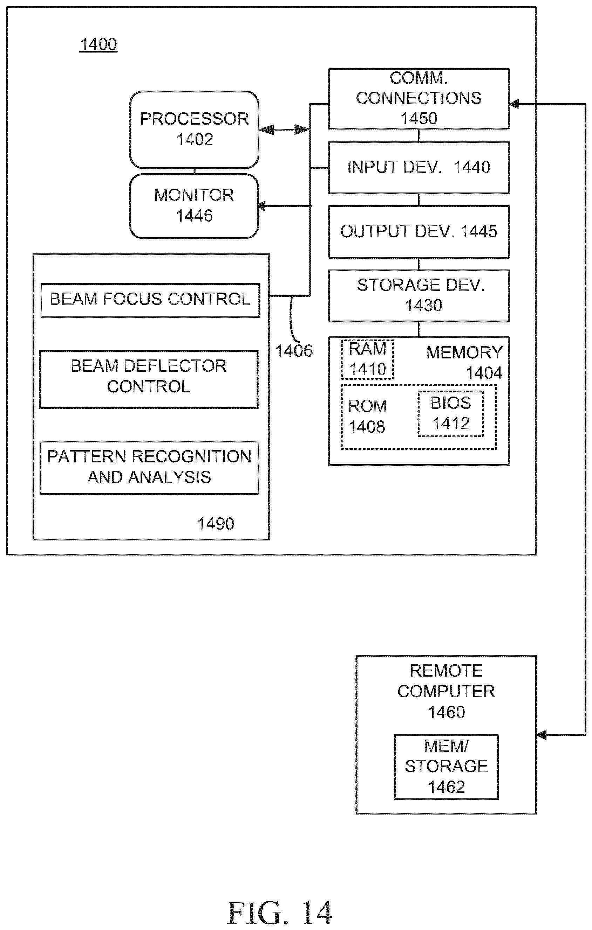

FIG. 14 and the following discussion are intended to provide a brief, general description of an exemplary computing environment in which the disclosed technology may be implemented. For example, one or more aspects of the computing system of FIG. 14 may represent and/or correspond to the controller 180 of FIG. 1. In particular, some or all portions of this computing environment can be used with the above methods and apparatus to, for example, control a CPM system to direct a charged particle beam to a specimen, to control a foil lens corrector to generate a suitable corrector electrostatic field to at least partially correct a spherical aberration of the charged particle beam, and/or perform any portions of the methods disclosed above.

Although not required, the disclosed technology is described in the general context of computer executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including hand-held devices, tablets, multiprocessor systems, microprocessor-based or programmable consumer electronics, network PCs, minicomputers, mainframe computers, virtual machines, containerized applications, and the like. The disclosed technology also may be practiced in distributed computing environments where tasks are performed by remote processing devices that are linked through a communications network. In a distributed computing environment, program modules may be located in both local and remote memory storage devices. In some cases, such processing is provided in a CPM system. The disclosed systems can serve to control image acquisition and provide a user interface as well as serve as an image processor.

With reference to FIG. 14, an exemplary system for implementing the disclosed technology includes a general-purpose computing device in the form of an exemplary PC 1400, including one or more processing units 1402, a system memory 1404, and a system bus 1406 that couples various system components including the system memory 1404 to the one or more processing units 1402. The system bus 1406 may be any of several types of bus structures including a memory bus or memory controller, a peripheral bus, and a local bus using any of a variety of bus architectures. The exemplary system memory 1404 includes read-only memory (ROM) 1408 and random-access memory (RAM) 1410. A basic input/output system (BIOS) 1412, containing the basic routines that help with the transfer of information between elements within the PC 1400, is stored in ROM 1408. The PC 1400 may represent and/or correspond to the controller 180 of FIG. 1.

The exemplary PC 1400 further includes one or more storage devices 1430 such as a hard disk drive for reading from and writing to a hard disk, a magnetic disk drive for reading from or writing to a removable magnetic disk, and an optical disk drive for reading from or writing to a removable optical disk (such as a CD-ROM or other optical media). Such storage devices can be connected to the system bus 1406 by a hard disk drive interface, a magnetic disk drive interface, and an optical drive interface, respectively. The drives and their associated computer readable media provide nonvolatile storage of computer-readable instructions, data structures, program modules, and other data for the PC 1400. Other types of computer-readable media which can store data that is accessible by a PC, such as magnetic cassettes, flash memory cards, solid-state drives, digital video disks, CDs, DVDs, RAMs, ROMs, and the like, may also be used in the exemplary operating environment. A number of program modules may be stored in the storage devices 1430 including an operating system, multiple operating systems, virtual operating systems, one or more application programs, other program modules, and/or program data.

The exemplary PC 1400 can include various devices configured for user interface. For example, a user may enter commands and information into the PC 1400 through one or more input devices 1440 such as a keyboard and/or a pointing device such as a mouse. For example, the user may enter commands to initiate image acquisition and/or to initiate one or more methods disclosed herein. Other input devices may include a digital camera, microphone, joystick, game pad, buttons, dials, satellite dish, scanner, or the like. These and other input devices are often connected to the one or more processing units 1402 through a serial port interface that is coupled to the system bus 1406, but may be connected by other interfaces such as a parallel port, game port, universal serial bus (USB), or wired or wireless network connection. A monitor 1446 or other type of display device is also connected to the system bus 1406 via an interface, such as a video adapter, and can display, for example, one or more images of a specimen or sample prior to, subsequent to, and/or during performance of one or more methods disclosed herein. The monitor 1446 can also be used to select sections for processing or particular image alignment and alignment procedures such as correlation, feature identification, and preview area selection or other image selection. Other peripheral output devices, such as speakers and printers (not shown), may be included.

The PC 1400 may operate in a networked environment using logical connections to one or more remote computers, such as a remote computer 1460. In some examples, one or more network or communication connections 1450 are included. The remote computer 1460 may be another PC, a server, a router, a network PC, and/or a peer device or other common network node, and typically includes many or all of the elements described above relative to the PC 1400, although only a memory storage device 1462 has been illustrated in FIG. 14. The personal computer 1400 and/or the remote computer 1460 can be connected to a local area network (LAN) and/or a wide area network (WAN). Such networking environments are commonplace in offices, enterprise wide computer networks, intranets, and the Internet.

As shown in FIG. 14, a memory 1490 (or portions of this or other memory) can store processor-executable instructions for regulating the booster tube voltage, for regulating one or more voltages associated with the electrode assembly of the foil lens corrector, and/or for any other processes described herein. For example, such processor-executable instructions can, when executed by a processor system, cause the PC 1400 and/or another component (e.g., any suitable components of any CPM system and/or foil lens corrector disclosed herein) to execute any of the methods disclosed herein. In addition, the memory 1490 can include processor-executable instructions for setting cross-correlations, image alignment such as image rotation and translation, selection of reference images and regions of interest, and/or recording stage coordinates for alignment. In some examples, processor-executable instructions can produce displayed images showing section identification, processing of preview images, and/or acquisition of additional images.

### General Considerations

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

Unless otherwise stated, as used herein, the term "substantially" means the listed value and/or property and any value and/or property that is at least 75% of the listed value and/or property. Equivalently, the term "substantially" means the listed value and/or property and any value and/or property that differs from the listed value and/or property by at most 25%. For example, "substantially equal" refers to quantities that are fully equal, as well as to quantities that differ from one another by up to 25%.

The systems, apparatus, and methods described herein should not be construed as limiting in any way. Instead, the present disclosure is directed toward all novel and non-obvious features and aspects of the various disclosed examples, alone and in various combinations and subcombinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, and the like may be characterized by qualifying terms such as "lowest," "best," "minimum ," "extreme," etc. It is to be understood that such descriptions are intended to indicate that a selection among many used functional alternatives can be made, and such selections need not be better, smaller, or otherwise preferable to other selections.

The innovations can be described in the general context of computer-executable instructions, such as those included in program modules, being executed in a computing system on a target real or virtual processor. Generally, program modules or components include routines, programs, libraries, objects, classes, components, data structures, etc. that perform particular tasks or implement particular abstract data types. The functionality of the program modules may be combined or split between program modules as desired in various examples. Computer-executable instructions for program modules may be executed within a local or distributed computing system. In general, a computing system or computing device can be local or distributed, and can include any combination of special-purpose hardware and/or general-purpose hardware with software implementing the functionality described herein, examples of which include personal computers, hand-held devices, tablets, multiprocessor systems, microprocessor-based or programmable consumer electronics, network PCs, minicomputers, mainframe computers, virtual machines, containerized applications, etc.

In various examples described herein, a module (e.g., component or engine) can be "programmed" and/or "coded" to perform certain operations or provide certain functionality, indicating that computer-executable instructions for the module can be executed to perform such operations, cause such operations to be performed, or to otherwise provide such functionality. Although functionality described with respect to a software component, module, or engine can be carried out as a discrete software unit (e.g., program, function, class method), it need not be implemented as a discrete unit. That is, the functionality can be incorporated into a larger or more general-purpose program, such as one or more lines of code in a larger or general-purpose program.

Described algorithms may be, for example, embodied as software or firmware instructions carried out by a digital computer. For instance, any of the disclosed methods can be performed by one or more a computers or other computing hardware that is part of a microscopy tool. The computers can be computer systems comprising one or more processors (processing devices) and tangible, non-transitory computer-readable media (e.g., one or more optical media discs, volatile memory devices (such as DRAM or SRAM), or nonvolatile memory or storage devices (such as hard drives, NVRAM, and solid-state drives (e.g., Flash drives)). The one or more processors can execute computer-executable instructions stored on one or more of the tangible, non-transitory computer-readable media, and thereby perform any of the disclosed techniques. For instance, software for performing any of the disclosed examples can be stored on the one or more volatile, non-transitory computer-readable media as computer-executable instructions, which when executed by the one or more processors, cause the one or more processors to perform any of the disclosed techniques or subsets of techniques.

### Additional Examples of the Disclosed Technology

Having described and illustrated the principles of the disclosed technology with reference to the illustrated examples, it will be recognized that the illustrated examples can be modified in arrangement and detail without departing from such principles. For instance, elements of examples performed in software may be implemented in hardware and vice-versa. Also, the technologies from any example can be combined with the technologies described in any one or more of the other examples. It will be appreciated that procedures and functions such as those described with reference to the illustrated examples can be implemented in a single hardware or software module, or separate modules can be provided. The particular arrangements above are provided for convenient illustration, and other arrangements can be used.

Example 1. A foil lens corrector for correcting spherical aberration in a charged particle beam generated by a charged particle microscope (CPM) system, the foil lens corrector comprising: a graphene foil configured to be positioned in line with an optical axis of the CPM system; and an electrode assembly configured to generate a corrector electrostatic potential on a first side of the foil, wherein the foil is configured to support a space charge such that the optical axis intersects the space charge, and wherein the foil lens corrector is configured such that the corrector electrostatic potential generates an offsetting spherical aberration in the charged particle beam.

Example 2. A foil lens corrector for correcting spherical aberration in a charged particle beam generated by a charged particle microscope (CPM) system, the foil lens corrector comprising: a foil configured to be positioned in line with an optical axis of the CPM system; and an electrode assembly configured to generate a corrector electrostatic potential, wherein the foil comprises graphene and wherein the foil is configured to support a space charge such that the optical axis intersects the space charge.

Example 3. The foil lens corrector of any example herein, particularly example 2, wherein the foil lens corrector is configured such that the corrector electrostatic potential generates an offsetting spherical aberration in the charged particle beam to at least partially correct a spherical aberration in the charged particle beam.

Example 4. The foil lens corrector of any example herein, particularly example 3, wherein the offsetting spherical aberration is a negative spherical aberration.

Example 5. The foil lens corrector of any example herein, particularly example 4, wherein the negative spherical aberration generated by the foil lens corrector is characterized by a third order spherical aberration coefficient at a specimen plane downstream of the foil lens corrector that is one or more of at least -20 millimeters (mm), at least -15 mm, at least -10 mm, at least -5 mm, at least -1 mm, at most 0 mm, at most -2 mm, at most -7 mm, at most -12 mm, or at most -17 mm.

Example 6. The foil lens corrector of any example herein, particularly any one of examples 2-5, wherein the offsetting spherical aberration is a positive spherical aberration.

Example 7. The foil lens corrector of any example herein, particularly example 6, wherein the positive spherical aberration generated by the foil lens corrector is characterized by a third order spherical aberration coefficient at a specimen plane downstream of the foil lens corrector that is one or more of at least 0 mm, at least 2 mm, at least 7 mm, at least 12 mm, at least 17 mm, at most 20 mm, at most 15 mm, at most 10 mm, at most 5 mm, or at most 1 mm.

Example 8. The foil lens corrector of any example herein, particularly any one of examples 2-5, wherein the foil lens corrector is configured to operate as a convergent lens upon the charged particle beam.

Example 9. The foil lens corrector of any example herein, particularly any one of examples 2-8, wherein the foil lens corrector is configured to operate as a divergent lens upon the charged particle beam.

Example 10. The foil lens corrector of any example herein, particularly any one of examples 2-9, wherein the foil comprises one of: (i) single-layer graphene; (ii) two-layer graphene; (iii) three-layer graphene; or (iv) more than three layers of graphene.

Example 11. The foil lens corrector of any example herein, particularly any one of examples 2-10, wherein the foil lens corrector is configured such that, during operative use of the CPM system, when the charged particle beam is incident upon the foil with a foil landing energy, the charged particle beam is transmitted through the foil with a transmission ratio that is one or more of at least 5%, at least 10%, at least 20%, at least 30%, at least 50%, at least 70%, at least 80%, at most 95%, at most 75%, at most 60%, at most 40%, at most 25%, at most 15%, or at most 7%.

Example 12. The foil lens corrector of any example herein, particularly example 11, wherein the foil landing energy is one or more of at least 5 kiloelectronvolts (keV), at least 7 keV, at least 10 keV, at least 15 keV, at least 20 keV, at least 30 keV, at least 50 keV, at 70 keV, at most 80 keV, at most 60 keV, at most 40 keV, at most 25 keV, at most 17 keV, at most 12 keV, at most 8 keV, at most 6 keV, 5-8 keV, 7-12 keV, 5-15 keV, 5-20 keV, 5-30 keV, 5-40 keV, 5-60 keV, or 5-80 keV.

Example 13. The foil lens corrector of any example herein, particularly any one of examples 2-12, wherein the electrode assembly is configured to generate the corrector electrostatic potential on a first side of the foil, and wherein the foil is configured to shield the corrector electrostatic potential such that a maximum magnitude of the corrector electrostatic potential generated by the electrode assembly on a second side of the foil opposite to the first side of the foil is at most 1% of a maximum magnitude of the corrector electrostatic potential on the first side of the foil.

Example 14. The foil lens corrector of any example herein, particularly any one of examples 2-13, wherein the electrode assembly comprises an electrode configured to generate at least a portion of the corrector electrostatic potential on a first side of the foil, and wherein the foil is configured to at least partially shield the corrector electrostatic potential from extending to a second side of the foil opposite to the first side of the foil.

Example 15. The foil lens corrector of any example herein, particularly any one of examples 2-14, wherein the electrode assembly comprises a first electrode and a second electrode, and wherein the foil lens corrector is configured to generate at least a portion of the corrector electrostatic potential by applying a first electrode voltage to the first electrode and applying a second electrode voltage to the second electrode while the foil is maintained at a foil potential that is different from one or both of the first electrode voltage and the second electrode voltage.

Example 16. The foil lens corrector of any example herein, particularly example 15, wherein each of the first electrode and the second electrode are positioned on a common side of the foil.

Example 17. The foil lens corrector of any example herein, particularly any one of examples 2-16, wherein the electrode assembly is configured to generate the corrector electrostatic potential upstream of the foil.

Example 18. The foil lens corrector of any example herein, particularly any one of examples 2-17, wherein the electrode assembly is configured to generate the corrector electrostatic potential downstream of the foil.

Example 19. The foil lens corrector of any example herein, particularly any one of examples 2-18, wherein the CPM system comprises a booster tube configured to accelerate the charged particle beam within at least a portion of the CPM system, and wherein at least a portion of the foil lens corrector is electrically coupled to the booster tube.

Example 20. The foil lens corrector of any example herein, particularly example 19, wherein the foil is electrically coupled to the booster tube.

Example 21. The foil lens corrector of any example herein, particularly any one of examples 19-20, further comprising a corrector housing that electrically couples the booster tube to the foil.

Example 22. The foil lens corrector of any example herein, particularly any one of examples 19-21, wherein the foil lens corrector is configured to be positioned within the booster tube.

Example 23. The foil lens corrector of any example herein, particularly any one of examples 19-22, wherein the booster tube is configured to accelerate the charged particle beam to a boosted potential along the optical axis within the booster tube, and wherein the foil lens corrector is configured such that a total electrostatic potential magnitude on the optical axis within the foil lens corrector is less than the boosted potential.

Example 24. The foil lens corrector of any example herein, particularly example 23, wherein the boosted potential is one or more of at least 4 keV, at least 6 keV, at least 8 keV, at least 10 keV, at least 12 keV, at most 14 keV, at most 11 keV, at most 9 keV, at most 7 keV, at most 5 keV, 4-9 keV, 6-11 keV, 8-14 keV, or 4-14 keV.

Example 25. The foil lens corrector of any example herein, particularly any one of examples 2-24, further comprising a shielding electrode that defines a foil aperture, wherein the foil extends across the foil aperture.

Example 26. The foil lens corrector of any example herein, particularly example 25, wherein the foil fully covers the foil aperture.

Example 27. The foil lens corrector of any example herein, particularly any one of examples 25-26, wherein the foil aperture is a circular aperture.

Example 28. The foil lens corrector of any example herein, particularly any one of examples 25-27, wherein the foil aperture has a foil aperture diameter that is one or more of at least 50 microns (µm), at least 100 µm, at least 200 µm, at least 300 µm, at least 500 µm, at most 700 µm, at most 400 µm, at most 250 µm, at most 150 µm, or at most 75 µm.

Example 29. The foil lens corrector of any example herein, particularly any one of examples 25-28, wherein the foil is freestanding across the foil aperture.

Example 30. The foil lens corrector of any example herein, particularly any one of examples 25-28, wherein the foil is supported by a foil support structure that extends at least partially across the foil aperture.

Example 31. The foil lens corrector of any example herein, particularly example 30, wherein the foil support structure comprises one or more of a grid, a mesh, or a perforated structure.

Example 32. The foil lens corrector of any example herein, particularly any one of examples 2-31, further comprising one or both of: (i) a first shielding electrode that supports the foil; and (ii) a second shielding electrode positioned such that the electrode assembly is positioned between the first shielding electrode and the second shielding electrode.

Example 33. The foil lens corrector of any example herein, particularly example 32, wherein the second shielding electrode is electrically coupled to the first shielding electrode.

Example 34. The foil lens corrector of any example herein, particularly any one of examples 32-33, wherein the first shielding electrode comprises a foil aperture that is at least partially covered by the foil, and wherein the second shielding electrode comprises a second aperture that is axially aligned with the foil aperture.

Example 35. The foil lens corrector of any example herein, particularly any one of examples 2-34, further comprising a corrector housing that supports one or both of the foil and at least a portion of the electrode assembly.

Example 36. The foil lens corrector of any example herein, particularly example 35, wherein the electrode assembly comprises one or more electrodes configured to generate at least a portion of the corrector electrostatic potential, and wherein the one or more electrodes are electrically insulated from the corrector housing.

Example 37. The foil lens corrector of any example herein, particularly any one of examples 35-36, further comprising an insulating support that supports the one or more electrodes relative to the corrector housing and that electrically insulates the one or more electrodes from the corrector housing.

Example 38. The foil lens corrector of any example herein, particularly any one of examples 35-37, wherein the electrode assembly comprises one or more electrodes configured to generate at least a portion of the corrector electrostatic potential, and wherein the corrector housing supports the one or more electrodes at least partially within corrector housing.

Example 39. The foil lens corrector of any example herein, particularly any one of examples 35-38, wherein the corrector housing comprises a foil aperture, and wherein the foil is coupled to the corrector housing and covers the foil aperture.

Example 40. The foil lens corrector of any example herein, particularly example 39, wherein the foil fully covers the foil aperture.

Example 41. The foil lens corrector of any example herein, particularly any one of examples 39-40, wherein the foil aperture is a circular aperture.

Example 42. The foil lens corrector of any example herein, particularly any one of examples 39-41, wherein the foil aperture has a foil aperture diameter that is one or more of at least 50 µm, at least 100 µm, at least 200 µm, at least 300 µm, at least 500 µm, at most 700 µm, at most 400 µm, at most 250 µm, at most 150 µm, or at most 75 µm.

Example 43. The foil lens corrector of any example herein, particularly any one of examples 35-42, wherein the corrector housing comprises one or both of: (i) a first shielding electrode that supports the foil; and (ii) a second shielding electrode positioned such that the electrode assembly is positioned between the first shielding electrode and the second shielding electrode.

Example 44. The foil lens corrector of any example herein, particularly example 43, wherein one or both of the first shielding electrode and the second shielding electrode are configured to one or both of shape the corrector electrostatic potential within the corrector housing and at least partially confine the corrector electrostatic potential within the corrector housing.

Example 45. The foil lens corrector of any example herein, particularly any one of examples 43-44, wherein the second shielding electrode is electrically coupled to the first shielding electrode.

Example 46. The foil lens corrector of any example herein, particularly any one of examples 43-45, wherein the corrector housing comprises a housing body that is in direct contact with each of the first shielding electrode and the second shielding electrode.

Example 47. The foil lens corrector of any example herein, particularly any one of examples 43-46, wherein the first shielding electrode comprises a foil aperture.

Example 48. The foil lens corrector of any example herein, particularly example 47, wherein the second shielding electrode comprises a second aperture that is axially aligned with the foil aperture.

Example 49. The foil lens corrector of any example herein, particularly any one of examples 2-48, further comprising a corrector heater configured to heat the foil.

Example 50. The foil lens corrector of any example herein, particularly example 49, wherein the corrector heater is configured to heat the foil to a temperature that is approximately 200 °C.

Example 51. The foil lens corrector of any example herein, particularly any one of examples 49-50, wherein the corrector heater is configured to heat the foil during operative use of the foil lens corrector.

Example 52. The foil lens corrector of any example herein, particularly any one of examples 49-51, wherein the corrector heater is configured to heat the foil during operative use of the CPM system.

Example 53. The foil lens corrector of any example herein, particularly any one of examples 49-52, wherein the corrector heater comprises a heating element configured to receive an electrical current and a heater body, and wherein the heating element is thermally coupled to the foil via the heater body.

Example 54. The foil lens corrector of any example herein, particularly example 53, wherein the heater body comprises an electrically insulating portion and an electrically conductive portion.

Example 55. The foil lens corrector of any example herein, particularly any one of examples 53-54, wherein the electrically insulating portion is in direct contact with each of the heating element and the electrically conductive portion.

Example 56. The foil lens corrector of any example herein, particularly any one of examples 53-55, wherein the electrically insulating portion comprises aluminum nitride.

Example 57. The foil lens corrector of any example herein, particularly any one of examples 53-56, wherein the electrically conductive portion in direct contact with the foil.

Example 58. The foil lens corrector of any example herein, particularly any one of examples 53-57, further comprising a corrector housing that supports one or both of the foil and at least a portion of the electrode assembly, and wherein the electrically conductive portion is in direct contact with the corrector housing.

Example 59. The foil lens corrector of any example herein, particularly any one of examples 53-58, wherein the electrically conductive portion comprises molybdenum.

Example 60. The foil lens corrector of any example herein, particularly any one of examples 53-59, wherein the electrically conductive portion defines at least a portion of a heater conduit configured to allow the charged particle beam to pass through the heater body.

Example 61. The foil lens corrector of any example herein, particularly any one of examples 53-60, wherein the heating element is electrically isolated from the foil.

Example 62. The foil lens corrector of any example herein, particularly any one of examples 53-61, further comprising a corrector housing that supports one or both of the foil and at least a portion of the electrode assembly, and wherein the heater body electrically isolates the heating element from one or both of the foil and the corrector housing.

Example 63. The foil lens corrector of any example herein, particularly any one of examples 53-62, wherein the heater body comprises aluminum nitride.

Example 64. The foil lens corrector of any example herein, particularly any one of examples 53-63, further comprising a corrector housing that supports one or both of the foil and at least a portion of the electrode assembly, and wherein the heater body is in direct contact with one or both of the foil and the corrector housing.

Example 65. The foil lens corrector of any example herein, particularly any one of examples 53-64, further comprising a corrector housing that supports one or both of the foil and at least a portion of the electrode assembly, and wherein the heating element is spaced apart from one or both of the foil and the corrector housing.

Example 66. The foil lens corrector of any example herein, particularly any one of examples 53-65, wherein one or both of the heating element and the heater body defines at least a portion of a heater conduit configured to allow the charged particle beam to pass through one or both of the corrector heater and the heater body.

Example 67. The foil lens corrector of any example herein, particularly any one of examples 49-66, further comprising a corrector housing that supports one or both of the foil and at least a portion of the electrode assembly, wherein the corrector housing defines a housing indentation that extends toward the electrode assembly, and wherein at least a portion of the corrector heater is received within the housing indentation.

Example 68. The foil lens corrector of any example herein, particularly any one of examples 2-67, wherein the CPM system comprises a scanning electron microscope (SEM).

Example 69. The foil lens corrector of any example herein, particularly any one of examples 2-68, wherein the CPM system comprises a transmission electron microscope (TEM).

Example 70. The foil lens corrector of any example herein, particularly any one of examples 2-69, wherein the CPM system comprises one or more scanning deflectors configured to scan the charged particle beam relative to a specimen, and wherein the foil lens corrector is positioned upstream of the one or more scanning deflectors.

Example 71. The foil lens corrector of any example herein, particularly any one of examples 2-70, wherein the CPM system comprises an objective lens assembly, and wherein the foil lens corrector is positioned upstream of at least a portion of the objective lens assembly.

Example 72. The foil lens corrector of any example herein, particularly any one of examples 2-71, wherein the CPM system comprises a condenser lens assembly, and wherein the foil lens corrector is positioned downstream of at least a portion of the condenser lens assembly.

Example 73. A foil lens corrector for correcting spherical aberration in a charged particle beam generated by a charged particle microscope (CPM) system, the foil lens corrector comprising: a foil configured to be positioned in line with an optical axis of the CPM system; and an electrode assembly configured to generate a corrector electrostatic potential on a first side of the foil, wherein the foil is configured to support a space charge such that the optical axis intersects the space charge, wherein the foil lens corrector is configured such that, during operative use of the CPM system, the corrector electrostatic potential generates an offsetting spherical aberration in the charged particle beam to at least partially correct a spherical aberration in the charged particle beam when the charged particle beam is incident upon the foil with a foil landing energy that is at least 5 keV and at most 80 keV and when the charged particle beam is transmitted through the foil with a transmission ratio that is at least 20%.

Example 74. A foil lens corrector for correcting spherical aberration in a charged particle beam generated by a charged particle microscope (CPM) system, the foil lens corrector comprising: a corrector housing; a foil supported by the corrector housing; and an electrode assembly supported by the corrector housing and configured to generate a corrector electrostatic potential, wherein the corrector housing is configured to support the foil in line with an optical axis of the CPM system, wherein the foil is configured to support a space charge such that the optical axis intersects the space charge, and wherein the foil lens corrector is configured such that, during operative use of the CPM system, the charged particle beam is incident upon the foil with a foil landing energy that is at least 5 keV and at most 80 keV and the charged particle beam is transmitted through the foil with a transmission ratio that is at least 20%.

Example 75. The foil lens corrector of any example herein, particularly example 74, wherein the foil lens corrector is configured to generate a negative spherical aberration in the charged particle beam.

Example 76. The foil lens corrector of any example herein, particularly example 75, wherein the negative spherical aberration generated by the foil lens corrector is characterized by a third order spherical aberration coefficient at a specimen plane downstream of the foil lens corrector that is one or more of at least -20 millimeters (mm), at least -15 mm, at least -10 mm, at least -5 mm, at most -2 mm, at most -7 mm, at most -12 mm, or at most -17 mm.

Example 77. The foil lens corrector of any example herein, particularly any one of examples 74-76, wherein the foil lens corrector is configured to generate a positive spherical aberration in the charged particle beam.

Example 78. The foil lens corrector of any example herein, particularly example 77, wherein the positive spherical aberration generated by the foil lens corrector is characterized by a third order spherical aberration coefficient at a specimen plane downstream of the foil lens corrector that is one or more of at least 0 mm, at least 2 mm, at least 7 mm, at least 12 mm, at least 17 mm, at most 20 mm, at most 15 mm, at most 10 mm, at most 5 mm, or at most 1 mm.

Example 79. The foil lens corrector of any example herein, particularly any one of examples 74-78, wherein the foil lens corrector is configured to operate as a convergent lens upon the charged particle beam.

Example 80. The foil lens corrector of any example herein, particularly any one of examples 74-79, wherein the foil lens corrector is configured to operate as a divergent lens upon the charged particle beam.

Example 81. The foil lens corrector of any example herein, particularly any one of examples 74-80, wherein the foil comprises graphene.

Example 82. The foil lens corrector of any example herein, particularly any one of examples 74-81, wherein the foil comprises one of: (i) single-layer graphene; (ii) two-layer graphene; (iii) three-layer graphene; or (iv) more than three layers of graphene.

Example 83. The foil lens corrector of any example herein, particularly any one of examples 74-82, wherein the electrode assembly is configured to generate the corrector electrostatic potential on a first side of the foil, and wherein the foil is configured to shield the corrector electrostatic potential such that a maximum magnitude of the corrector electrostatic potential generated by the electrode assembly on a second side of the foil opposite to the first side of the foil is at most 1% of a maximum magnitude of the corrector electrostatic potential on the first side of the foil.

Example 84. The foil lens corrector of any example herein, particularly any one of examples 74-83, wherein the electrode assembly comprises an electrode configured to generate at least a portion of the corrector electrostatic potential on a first side of the foil, and wherein the foil is configured to at least partially shield the corrector electrostatic potential from extending to a second side of the foil opposite to the first side of the foil.

Example 85. The foil lens corrector of any example herein, particularly any one of examples 74-84, wherein the electrode assembly comprises a first electrode and a second electrode, and wherein the foil lens corrector is configured to generate at least a portion of the corrector electrostatic potential by applying a first electrode voltage to the first electrode and applying a second electrode voltage to the second electrode while the foil is maintained at a foil potential that is different from one or both of the first electrode voltage and the second electrode voltage.

Example 86. The foil lens corrector of any example herein, particularly example 85, wherein each of the first electrode and the second electrode are positioned on a common side of the foil.

Example 87. The foil lens corrector of any example herein, particularly any one of examples 74-86, wherein the electrode assembly is configured to generate the corrector electrostatic potential upstream of the foil.

Example 88. The foil lens corrector of any example herein, particularly any one of examples 74-87, wherein the electrode assembly is configured to generate the corrector electrostatic potential downstream of the foil.

Example 89. The foil lens corrector of any example herein, particularly any one of examples 74-88, wherein the CPM system comprises a booster tube configured to accelerate the charged particle beam within at least a portion of the CPM system, and wherein at least a portion of the foil lens corrector is electrically coupled to the booster tube.

Example 90. The foil lens corrector of any example herein, particularly example 89, wherein the foil is electrically coupled to the booster tube.

Example 91. The foil lens corrector of any example herein, particularly any one of examples 89-90, further comprising a corrector housing that electrically couples the booster tube to the foil.

Example 92. The foil lens corrector of any example herein, particularly any one of examples 89-91, wherein the foil lens corrector is configured to be positioned at least partially within the booster tube.

Example 93. The foil lens corrector of any example herein, particularly any one of examples 89-92, wherein the booster tube is configured to accelerate the charged particle beam to a boosted potential along the optical axis within the booster tube, and wherein the foil lens corrector is configured such that a total electrostatic potential magnitude on the optical axis within the foil lens corrector is less than a magnitude of the boosted potential.

Example 94. The foil lens corrector of any example herein, particularly example 93, wherein the boosted potential is one or more of at least 4 keV, at least 6 keV, at least 8 keV, at least 10 keV, at least 12 keV, at most 14 keV, at most 11 keV, at most 9 keV, at most 7 keV, at most 5 keV, 4-9 keV, 6-11 keV, 8-14 keV, or 4-14 keV.

Example 95. The foil lens corrector of any example herein, particularly any one of examples 74-94, further comprising a shielding electrode that defines a foil aperture, wherein the foil extends across the foil aperture.

Example 96. The foil lens corrector of any example herein, particularly example 95, wherein the foil fully covers the foil aperture.

Example 97. The foil lens corrector of any example herein, particularly any one of examples 95-96, wherein the foil aperture is a circular aperture.

Example 98. The foil lens corrector of any example herein, particularly any one of examples 95-97, wherein the foil aperture has a foil aperture diameter that is one or more of at least 50 µm, at least 100 µm, at least 200 µm, at least 300 µm, at least 500 µm, at most 700 µm, at most 400 µm, at most 250 µm, at most 150 µm, or at most 75 µm.

Example 99. The foil lens corrector of any example herein, particularly any one of examples 95-98, wherein the foil is freestanding across the foil aperture.

Example 100. The foil lens corrector of any example herein, particularly any one of examples 95-99, wherein the foil is supported by a foil support structure that extends at least partially across the foil aperture.

Example 101. The foil lens corrector of any example herein, particularly example 100, wherein the foil support structure comprises one or more of a grid, a mesh, or a perforated structure.

Example 102. The foil lens corrector of any example herein, particularly any one of examples 74-101, further comprising one or both of: (i) a first shielding electrode that supports the foil; and (ii) a second shielding electrode positioned such that the electrode assembly is positioned between the first shielding electrode and the second shielding electrode.

Example 103. The foil lens corrector of any example herein, particularly example 102, wherein the second shielding electrode is electrically coupled to the first shielding electrode.

Example 104. The foil lens corrector of any example herein, particularly any one of examples 101-103, wherein the first shielding electrode comprises a foil aperture that is at least partially covered by the foil, and wherein the second shielding electrode comprises a second aperture that is axially aligned with the foil aperture.

Example 105. The foil lens corrector of any example herein, particularly any one of examples 74-104, further comprising a corrector housing that supports one or both of the foil and at least a portion of the electrode assembly.

Example 106. The foil lens corrector of any example herein, particularly example 105, wherein the electrode assembly comprises one or more electrodes configured to generate at least a portion of the corrector electrostatic potential, and wherein the one or more electrodes are electrically insulated from the corrector housing.

Example 107. The foil lens corrector of any example herein, particularly any one of examples 105-106, further comprising an insulating support that supports the one or more electrodes relative to the corrector housing and that electrically insulates the one or more electrodes from the corrector housing.

Example 108. The foil lens corrector of any example herein, particularly any one of examples 105-107, wherein the electrode assembly comprises one or more electrodes configured to generate at least a portion of the corrector electrostatic potential, and wherein the corrector housing supports the one or more electrodes at least partially within corrector housing.

Example 109. The foil lens corrector of any example herein, particularly any one of examples 105-108, wherein the corrector housing comprises a foil aperture, and wherein the foil is coupled to the corrector housing and covers the foil aperture.

Example 110. The foil lens corrector of any example herein, particularly example 109, wherein the foil fully covers the foil aperture.

Example 111. The foil lens corrector of any example herein, particularly any one of examples 109-110, wherein the foil aperture is a circular aperture.

Example 112. The foil lens corrector of any example herein, particularly any one of examples 109-111, wherein the foil aperture has a foil aperture diameter that is one or more of at least 50 µm, at least 100 µm, at least 200 µm, at least 300 µm, at least 500 µm, at most 700 µm, at most 400 µm, at most 250 µm, at most 150 µm, or at most 75 µm.

Example 113. The foil lens corrector of any example herein, particularly any one of examples 105-112, wherein the corrector housing comprises one or both of: (i) a first shielding electrode that supports the foil; and (ii) a second shielding electrode positioned such that the electrode assembly is positioned between the first shielding electrode and the second shielding electrode.

Example 114. The foil lens corrector of any example herein, particularly example 113, wherein one or both of the first shielding electrode and the second shielding electrode are configured to one or both of shape the corrector electrostatic potential within the corrector housing and at least partially confine the corrector electrostatic potential within the corrector housing.

Example 115. The foil lens corrector of any example herein, particularly any one of examples 113-114, wherein the second shielding electrode is electrically coupled to the first shielding electrode.

Example 116. The foil lens corrector of any example herein, particularly any one of examples 113-115, wherein the corrector housing comprises a housing body that is in direct contact with each of the first shielding electrode and the second shielding electrode.

Example 117. The foil lens corrector of any example herein, particularly any one of examples 113-116, wherein the first shielding electrode comprises a foil aperture.

Example 118. The foil lens corrector of any example herein, particularly example 117, wherein the second shielding electrode comprises a second aperture that is axially aligned with the foil aperture.

Example 119. The foil lens corrector of any example herein, particularly any one of examples 64-118, further comprising a corrector heater configured to heat the foil.

Example 120. The foil lens corrector of any example herein, particularly example 119, wherein the corrector heater is configured to heat the foil to a temperature that is approximately 200 °C.

Example 121. The foil lens corrector of any example herein, particularly any one of examples 119-120, wherein the corrector heater is configured to heat the foil during operative use of the foil lens corrector.

Example 122. The foil lens corrector of any example herein, particularly any one of examples 119-121, wherein the corrector heater is configured to heat the foil during operative use of the CPM system.

Example 123. The foil lens corrector of any example herein, particularly any one of examples 119-122, wherein the corrector heater comprises a heating element configured to receive an electrical current and a heater body, and wherein the heating element is thermally coupled to the foil via the heater body.

Example 124. The foil lens corrector of any example herein, particularly example 123, wherein the heater body comprises an electrically insulating portion and an electrically conductive portion.

Example 125. The foil lens corrector of any example herein, particularly any one of examples 123-124, wherein the electrically insulating portion is in direct contact with each of the heating element and the electrically conductive portion.

Example 126. The foil lens corrector of any example herein, particularly any one of examples 123-125, wherein the electrically insulating portion comprises aluminum nitride.

Example 127. The foil lens corrector of any example herein, particularly any one of examples 123-126, wherein the electrically conductive portion in direct contact with the foil.

Example 128. The foil lens corrector of any example herein, particularly any one of examples 123-127, further comprising a corrector housing that supports one or both of the foil and at least a portion of the electrode assembly, and wherein the electrically conductive portion is in direct contact with the corrector housing.

Example 129. The foil lens corrector of any example herein, particularly any one of examples 123-128, wherein the electrically conductive portion comprises molybdenum.

Example 130. The foil lens corrector of any example herein, particularly any one of examples 123-129, wherein the electrically conductive portion defines at least a portion of a heater conduit configured to allow the charged particle beam to pass through the heater body.

Example 131. The foil lens corrector of any example herein, particularly any one of examples 123-130, wherein the heater body electrically isolates the heating element from one or both of the foil and the corrector housing.

Example 132. The foil lens corrector of any example herein, particularly any one of examples 123-131, wherein the heater body comprises aluminum nitride.

Example 133. The foil lens corrector of any example herein, particularly any one of examples 123-132, wherein the heater body is in direct contact with one or both of the foil and the corrector housing.

Example 134. The foil lens corrector of any example herein, particularly any one of examples 123-133, wherein the heating element is spaced apart from one or both of the foil and the corrector housing.

Example 135. The foil lens corrector of any example herein, particularly any one of examples 123-134, wherein one or both of the heating element and the heater body defines at least a portion of a heater conduit configured to allow the charged particle beam to pass through the corrector heater.

Example 136. The foil lens corrector of any example herein, particularly any one of examples 123-135, further comprising a corrector housing that supports one or both of the foil and at least a portion of the electrode assembly, wherein the corrector housing defines a housing indentation that extends toward the electrode assembly, and wherein at least a portion of the corrector heater is received within the housing indentation.

Example 137. The foil lens corrector of any example herein, particularly any one of examples 74-136, wherein the CPM system comprises a scanning electron microscope (SEM).

Example 138. The foil lens corrector of any example herein, particularly any one of examples 74-137, wherein the CPM system comprises a transmission electron microscope (TEM).

Example 139. The foil lens corrector of any example herein, particularly any one of examples 74-138, wherein the CPM system comprises one or more scanning deflectors configured to scan the charged particle beam relative to a specimen, and wherein the foil lens corrector is positioned upstream of the one or more scanning deflectors.

Example 140. The foil lens corrector of any example herein, particularly any one of examples 74-139, wherein the CPM system comprises an objective lens assembly, and wherein the foil lens corrector is positioned upstream of at least a portion of the objective lens assembly.

Example 141. The foil lens corrector of any example herein, particularly any one of examples 74-140, wherein the CPM system comprises a condenser lens assembly, and wherein the foil lens corrector is positioned downstream of at least a portion of the condenser lens assembly.

Example 142. A foil lens corrector for correcting spherical aberration in a charged particle beam generated by a charged particle microscope (CPM) system, the foil lens corrector comprising: a foil configured to be positioned in line with an optical axis of the CPM system; and an electrode assembly configured to generate a corrector electrostatic potential only on a first side of the foil, wherein the foil is configured to support a space charge such that the optical axis intersects the space charge, wherein the foil lens corrector is configured to operate as a convergent lens to generate an offsetting spherical aberration in the charged particle beam to at least partially correct a spherical aberration of the charged particle beam.

Example 143. A foil lens corrector for correcting spherical aberration in a charged particle beam generated by a charged particle microscope (CPM) system, the foil lens corrector comprising: a corrector housing; a foil supported by the corrector housing; and an electrode assembly supported by the corrector housing and configured to generate a corrector electrostatic potential only on a first side of the foil, wherein the corrector housing is configured to support the foil in line with an optical axis of the CPM system, wherein the foil is configured to support a space charge such that the optical axis intersects the space charge, and wherein the foil is configured to operate as a convergent lens upon the charged particle beam.

Example 144. The foil lens corrector of any example herein, particularly example 143, wherein the foil lens corrector is configured to generate a negative spherical aberration in the charged particle beam.

Example 145. The foil lens corrector of any example herein, particularly example 144, wherein the negative spherical aberration generated by the foil lens corrector is characterized by a third order spherical aberration coefficient at a specimen plane downstream of the foil lens corrector that is one or more of at least -20 millimeters (mm), at least -15 mm, at least -10 mm, at least -5 mm, at most -2 mm, at most -7 mm, at most -12 mm, or at most -17 mm.

Example 146. The foil lens corrector of any example herein, particularly example 143, wherein the foil lens corrector is configured to generate a positive spherical aberration in the charged particle beam.

Example 147. The foil lens corrector of any example herein, particularly example 146, wherein the positive spherical aberration generated by the foil lens corrector is characterized by a third order spherical aberration coefficient at a specimen plane downstream of the foil lens corrector that is one or more of at least 0 mm, at least 2 mm, at least 7 mm, at least 12 mm, at least 17 mm, at most 20 mm, at most 15 mm, at most 10 mm, at most 5 mm, or at most 1 mm.

Example 148. The foil lens corrector of any example herein, particularly any one of examples 143-147, wherein the foil lens corrector is configured to operate as a divergent lens upon the charged particle beam.

Example 149. The foil lens corrector of any example herein, particularly any one of examples 143-148, wherein the foil comprises graphene.

Example 150. The foil lens corrector of any example herein, particularly any one of examples 143-149, wherein the foil comprises one of: (i) single-layer graphene; (ii) two-layer graphene; (iii) three-layer graphene; or (iv) more than three layers of graphene.

Example 151. The foil lens corrector of any example herein, particularly any one of examples 143-150, wherein the foil lens corrector is configured such that, during operative use of the CPM system, when the charged particle beam is incident upon the foil with a foil landing energy, the charged particle beam is transmitted through the foil with a transmission ratio that is one or more of at least 5%, at least 10%, at least 20%, at least 30%, at least 50%, at least 70%, at least 80%, at most 95%, at most 75%, at most 60%, at most 40%, at most 25%, at most 15%, and/or at most 7%.

Example 152. The foil lens corrector of any example herein, particularly example 151, wherein the foil landing energy is one or more of at least 5 kiloelectronvolts (keV), at least 7 keV, at least 10 keV, at least 15 keV, at least 20 keV, at least 30 keV, at least 50 keV, at 70 keV, at most 80 keV, at most 60 keV, at most 40 keV, at most 25 keV, at most 17 keV, at most 12 keV, at most 8 keV, at most 6 keV, 5-8 keV, 7-12 keV, 5-15 keV, 5-20 keV, 5-30 keV, 5-40 keV, 5-60 keV, or 5-80 keV.

Example 153. The foil lens corrector of any example herein, particularly any one of examples 143-152, wherein the electrode assembly is configured to generate the corrector electrostatic potential on the first side of the foil, and wherein the foil is configured to shield the corrector electrostatic potential such that a maximum magnitude of the corrector electrostatic potential generated by the electrode assembly on a second side of the foil opposite to the first side of the foil is at most 1% of a maximum magnitude of the corrector electrostatic potential on the first side of the foil.

Example 154. The foil lens corrector of any example herein, particularly any one of examples 143-153, wherein the electrode assembly comprises an electrode configured to generate at least a portion of the corrector electrostatic potential on a first side of the foil, and wherein the foil is configured to at least partially shield the corrector electrostatic potential from extending to a second side of the foil opposite to the first side of the foil.

Example 155. The foil lens corrector of any example herein, particularly any one of examples 143-154, wherein the electrode assembly comprises a first electrode and a second electrode, and wherein the foil lens corrector is configured to generate at least a portion of the corrector electrostatic potential by applying a first electrode voltage to the first electrode and applying a second electrode voltage to the second electrode while the foil is maintained at a foil potential that is different from one or both of the first electrode voltage and the second electrode voltage.

Example 156. The foil lens corrector of any example herein, particularly example 155, wherein each of the first electrode and the second electrode are positioned on a common side of the foil.

Example 157. The foil lens corrector of any example herein, particularly any one of examples 143-156, wherein the electrode assembly is configured to generate the corrector electrostatic potential upstream of the foil.

Example 158. The foil lens corrector of any example herein, particularly any one of examples 143-157, wherein the electrode assembly is configured to generate the corrector electrostatic potential downstream of the foil.

Example 159. The foil lens corrector of any example herein, particularly any one of examples 143-158, wherein the CPM system comprises a booster tube configured to accelerate the charged particle beam within at least a portion of the CPM system, and wherein at least a portion of the foil lens corrector is electrically coupled to the booster tube.

Example 160. The foil lens corrector of any example herein, particularly example 159, wherein the foil is electrically coupled to the booster tube.

Example 161. The foil lens corrector of any example herein, particularly any one of examples 159-160, further comprising a corrector housing that electrically couples the booster tube to the foil.

Example 162. The foil lens corrector of any example herein, particularly any one of examples 159-161, wherein the foil lens corrector is configured to be positioned within the booster tube.

Example 163. The foil lens corrector of any example herein, particularly any one of examples 159-162, wherein the booster tube is configured to accelerate the charged particle beam to a boosted potential along the optical axis within the booster tube, and wherein the foil lens corrector is configured such that a total electrostatic potential magnitude on the optical axis within the foil lens corrector is less than a magnitude of the boosted potential.

Example 164. The foil lens corrector of any example herein, particularly example 163, wherein the boosted potential is one or more of at least 4 keV, at least 6 keV, at least 8 keV, at least 10 keV, at least 12 keV, at most 14 keV, at most 11 keV, at most 9 keV, at most 7 keV, at most 5 keV, 4-9 keV, 6-11 keV, 8-14 keV, or 4-14 keV.

Example 165. The foil lens corrector of any example herein, particularly any one of examples 143-164, further comprising a shielding electrode that defines a foil aperture, wherein the foil extends across the foil aperture.

Example 166. The foil lens corrector of any example herein, particularly example 165, wherein the foil fully covers the foil aperture.

Example 167. The foil lens corrector of any example herein, particularly any one of examples 165-166, wherein the foil aperture is a circular aperture.

Example 168. The foil lens corrector of any example herein, particularly any one of examples 165-167, wherein the foil aperture has a foil aperture diameter that is one or more of at least 50 µm, at least 100 µm, at least 200 µm, at least 300 µm, at least 500 µm, at most 700 µm, at most 400 µm, at most 250 µm, at most 150 µm, or at most 75 µm.

Example 169. The foil lens corrector of any example herein, particularly any one of examples 165-168, wherein the foil is freestanding across the foil aperture.

Example 170. The foil lens corrector of any example herein, particularly any one of examples 165-169, wherein the foil is supported by a foil support structure that extends at least partially across the foil aperture.

Example 171. The foil lens corrector of any example herein, particularly example 170, wherein the foil support structure comprises one or more of a grid, a mesh, or a perforated structure.

Example 172. The foil lens corrector of any example herein, particularly any one of examples 143-171, further comprising one or both of: (i) a first shielding electrode that supports the foil; and (ii) a second shielding electrode positioned such that the electrode assembly is positioned between the first shielding electrode and the second shielding electrode.

Example 173. The foil lens corrector of any example herein, particularly example 172, wherein the second shielding electrode is electrically coupled to the first shielding electrode.

Example 174. The foil lens corrector of any example herein, particularly any one of examples 172-173, wherein the first shielding electrode comprises a foil aperture that is at least partially covered by the foil, and wherein the second shielding electrode comprises a second aperture that is axially aligned with the foil aperture.

Example 175. The foil lens corrector of any example herein, particularly any one of examples 143-174, further comprising a corrector housing that supports one or both of the foil and at least a portion of the electrode assembly.

Example 176. The foil lens corrector of any example herein, particularly example 175, wherein the electrode assembly comprises one or more electrodes configured to generate at least a portion of the corrector electrostatic potential, and wherein the one or more electrodes are electrically insulated from the corrector housing.

Example 177. The foil lens corrector of any example herein, particularly any one of examples 175-176, further comprising an insulating support that supports the one or more electrodes relative to the corrector housing and that electrically insulates the one or more electrodes from the corrector housing.

Example 178. The foil lens corrector of any example herein, particularly any one of examples 174-177, wherein the electrode assembly comprises one or more electrodes configured to generate at least a portion of the corrector electrostatic potential, and wherein the corrector housing supports the one or more electrodes at least partially within corrector housing.

Example 179. The foil lens corrector of any example herein, particularly any one of examples 175-178, wherein the corrector housing comprises a foil aperture, and wherein the foil is coupled to the corrector housing and covers the foil aperture.

Example 180. The foil lens corrector of any example herein, particularly example 179, wherein the foil fully covers the foil aperture.

Example 181. The foil lens corrector of any example herein, particularly any one of examples 179-180, wherein the foil aperture is a circular aperture.

Example 182. The foil lens corrector of any example herein, particularly any one of examples 179-181, wherein the foil aperture has a foil aperture diameter that is one or more of at least 50 µm, at least 100 µm, at least 200 µm, at least 300 µm, at least 500 µm, at most 700 µm, at most 400 µm, at most 250 µm, at most 150 µm, or at most 75 µm.

Example 183. The foil lens corrector of any example herein, particularly any one of examples 179-182, wherein the corrector housing comprises one or both of: (i) a first shielding electrode that supports the foil; and (ii) a second shielding electrode positioned such that the electrode assembly is positioned between the first shielding electrode and the second shielding electrode.

Example 184. The foil lens corrector of any example herein, particularly example 183, wherein one or both of the first shielding electrode and the second shielding electrode are configured to one or both of shape the corrector electrostatic potential within the corrector housing and at least partially confine the corrector electrostatic potential within the corrector housing.

Example 185. The foil lens corrector of any example herein, particularly any one of examples 183-184, wherein the second shielding electrode is electrically coupled to the first shielding electrode.

Example 186. The foil lens corrector of any example herein, particularly any one of examples 183-185, wherein the corrector housing comprises a housing body that is in direct contact with each of the first shielding electrode and the second shielding electrode.

Example 187. The foil lens corrector of any example herein, particularly any one of examples 183-186, wherein the first shielding electrode comprises a foil aperture.

Example 188. The foil lens corrector of any example herein, particularly example 187, wherein the second shielding electrode comprises a second aperture that is axially aligned with the foil aperture.

Example 189. The foil lens corrector of any example herein, particularly any one of examples 143-188, further comprising a corrector heater configured to heat the foil.

Example 190. The foil lens corrector of any example herein, particularly example 189, wherein the corrector heater is configured to heat the foil to a temperature that is approximately 300 °C.

Example 191. The foil lens corrector of any example herein, particularly any one of examples 189-190, wherein the corrector heater is configured to heat the foil during operative use of the foil lens corrector.

Example 192. The foil lens corrector of any example herein, particularly any one of examples 189-191, wherein the corrector heater is configured to heat the foil during operative use of the CPM system.

Example 193. The foil lens corrector of any example herein, particularly any one of examples 189-192, wherein the corrector heater comprises a heating element configured to receive an electrical current and a heater body, and wherein the heating element is thermally coupled to the foil via the heater body.

Example 194. The foil lens corrector of any example herein, particularly example 193, wherein the heater body comprises an electrically insulating portion and an electrically conductive portion.

Example 195. The foil lens corrector of any example herein, particularly any one of examples 193-194, wherein the electrically insulating portion is in direct contact with each of the heating element and the electrically conductive portion.

Example 196. The foil lens corrector of any example herein, particularly any one of examples 193-195, wherein the electrically insulating portion comprises aluminum nitride.

Example 197. The foil lens corrector of any example herein, particularly any one of examples 193-196, wherein the electrically conductive portion in direct contact with the foil.

Example 198. The foil lens corrector of any example herein, particularly any one of examples 193-197, further comprising a corrector housing that supports one or both of the foil and at least a portion of the electrode assembly, and wherein the electrically conductive portion is in direct contact with the corrector housing.

Example 199. The foil lens corrector of any example herein, particularly any one of examples 193-198, wherein the electrically conductive portion comprises molybdenum.

Example 200. The foil lens corrector of any example herein, particularly any one of examples 193-199, wherein the electrically conductive portion defines at least a portion of a heater conduit configured to allow the charged particle beam to pass through the heater body.

Example 201. The foil lens corrector of any example herein, particularly any one of examples 193-200, wherein the heater body electrically isolates the heating element from one or both of the foil and the corrector housing.

Example 202. The foil lens corrector of any example herein, particularly any one of examples 193-201, wherein the heater body comprises aluminum nitride.

Example 203. The foil lens corrector of any example herein, particularly any one of examples 193-202, wherein the heater body is in direct contact with one or both of the foil and the corrector housing.

Example 204. The foil lens corrector of any example herein, particularly any one of examples 193-203, wherein the heating element is spaced apart from one or both of the foil and the corrector housing.

Example 205. The foil lens corrector of any example herein, particularly any one of examples 193-204, wherein one or both of the heating element and the heater body defines at least a portion of a heater conduit configured to allow the charged particle beam to pass through one or both of the corrector heater and the heater body.

Example 206. The foil lens corrector of any example herein, particularly any one of examples 193-205, further comprising a corrector housing that supports one or both of the foil and at least a portion of the electrode assembly, wherein the corrector housing defines a housing indentation that extends toward the electrode assembly, and wherein at least a portion of the corrector heater is received within the housing indentation.

Example 207. The foil lens corrector of any example herein, particularly any one of examples 143-206, wherein the CPM system comprises a scanning electron microscope (SEM).

Example 208. The foil lens corrector of any example herein, particularly any one of examples 143-207, wherein the CPM system comprises a transmission electron microscope (TEM).

Example 209. The foil lens corrector of any example herein, particularly any one of examples 143-208, wherein the CPM system comprises one or more scanning deflectors configured to scan the charged particle beam relative to a specimen, and wherein the foil lens corrector is positioned upstream of the one or more scanning deflectors.

Example 210. The foil lens corrector of any example herein, particularly any one of examples 143-209, wherein the CPM system comprises an objective lens assembly, and wherein the foil lens corrector is positioned upstream of at least a portion of the objective lens assembly.

Example 211. The foil lens corrector of any example herein, particularly any one of examples 143-210, wherein the CPM system comprises a condenser lens assembly, and wherein the foil lens corrector is positioned downstream of at least a portion of the condenser lens assembly.

Example 212. A CPM system comprising: a charged particle source configured to generate a charged particle beam; and a foil lens corrector for correcting spherical aberration in the charged particle beam, wherein the foil lens corrector is the foil lens corrector of any example herein, particularly any one of examples 1-211.

Example 213. The CPM system of any example herein, particularly example 212, wherein the CPM system comprises an SEM.

Example 214. The CPM system of any example herein, particularly any one of examples 212-213, wherein the CPM system comprises a TEM.

Example 215. The CPM system of any example herein, particularly any one of examples 212-214, further comprising an objective lens assembly configured to focus the charged particle beam upon a specimen, and wherein the foil lens corrector is positioned upstream of at least a portion of the objective lens assembly.

Example 216. The CPM system of any example herein, particularly any one of examples 212-215, further comprising one or more scanning deflectors configured to scan the charged particle beam relative to a specimen, and wherein the foil lens corrector is positioned upstream of the one or more scanning deflectors.

Example 217. The CPM system of any example herein, particularly any one of examples 212-216, further comprising a condenser lens assembly, and wherein the foil lens corrector is positioned downstream of at least a portion of the condenser lens assembly.

Example 218. The CPM system of any example herein, particularly any one of examples 212-217, further comprising an energy selection apparatus configured to transmit only a portion of the charged particle beam that is characterized by a charged particle energy that is within a selected energy bandwidth.

Example 219. The CPM system of any example herein, particularly example 218, wherein the energy selection apparatus comprises a monochromator.

Example 220. The CPM system of any example herein, particularly any one of examples 212-219, further comprising a booster tube configured to accelerate the charged particle beam within at least a portion of the CPM system, and wherein the foil lens corrector is at least partially positioned within the booster tube.

Example 221. The CPM system of any example herein, particularly example 220, wherein the charged particle beam comprises an electron beam, and wherein the booster tube is configured to be maintained at a positive voltage.

Example 222. The CPM system of any example herein, particularly any one of examples 220-221, wherein the foil is electrically coupled to the booster tube.

Example 223. The CPM system of any example herein, particularly any one of examples 220-222, wherein the foil lens corrector comprises a corrector housing that supports the foil, and wherein the corrector housing electrically couples the booster tube to the foil.

Example 224. The CPM system of any example herein, particularly any one of examples 220-223, wherein the booster tube is configured to accelerate the charged particle beam to a boosted potential within the booster tube, and wherein the foil lens corrector is configured such that the corrector electrostatic potential decreases a magnitude of a total electrostatic potential along an optical axis within the corrector housing to a magnitude that is less than the boosted potential.

Example 225. The CPM system of any example herein, particularly example 224, wherein the boosted potential is one or more of at least 4 keV, at least 6 keV, at least 8 keV, at least 10 keV, at least 12 keV, at most 14 keV, at most 11 keV, at most 9 keV, at most 7 keV, at most 5 keV, 4-9 keV, 6-11 keV, 8-14 keV, or 4-14 keV.

Example 226. The CPM system of any example herein, particularly any one of examples 212-225, wherein the CPM system is configured to direct the charged particle beam to a specimen plane, and wherein the CPM system is configured such that the charged particle beam has a specimen landing energy at the specimen plane that is one or more of at least 10 eV, at least 50 eV, at least 100 eV, at least 300 eV, at least 500 eV, at least 1000 eV, at least 5000 eV, at least 10 keV, at most 50 keV, at most 30 keV, at most 7000 eV, at most 2000 eV, at most 1500 eV, at most 700 eV, at most 200 eV, at most 70 eV, at most 20 eV, 10-100 eV, 50-500 eV, 100-1000 eV, 300-1500 eV, 500-2000 eV, 1000 eV-30 keV, or 5000 eV-50 keV.

Example 227. The CPM system of any example herein, particularly any one of examples 212-226, wherein the CPM system is configured to direct the charged particle beam to a specimen plane with a beam current that is one or more of at least 10 picoamperes (pA), at least 30 pA, at least 50 pA, at least 100 pA, at least 300 pA, at least 500 pA, at least 1000 pA, at most 2000 pA, at most 700 pA, at most 400 pA, at most 200 pA, at most 70 pA, at most 40 pA, or at most 20 pA.

Example 228. The CPM system of any example herein, particularly any one of examples 212-227, wherein the CPM system is configured to scan the charged particle beam across a specimen to yield field of view that is one or more of at least 50 nanometers (nm), at least 100 nm, at least 200 nm, at least 300 nm, at most 500 nm, at most 250 nm, at most 150 nm, or at most 75 nm.

Example 229. The CPM system of any example herein, particularly any one of examples 212-228, wherein the CPM system is configured to focus the charged particle beam in a specimen plane to a spot with a characteristic beam diameter that is one or more of at least 0.2 nm, at least 0.5 nm, at least 1 nm, at least 3 nm, at least 5 nm, at most 10 nm, at most 4 nm, at most 2 nm, at most 0.7 nm, at most 0.2 nm, 0.2-1 nm, 0.5-5 nm, or 1-10 nm.

Example 230. The CPM system of any example herein, particularly any one of examples 212-229, wherein the CPM system is configured such that the charged particle beam has a spherical aberration in a specimen plane that is characterized by a third order spherical aberration coefficient with a magnitude that is one or more of at most 5 mm, at most 3 mm, at most 1 mm, at most 0.5 mm, or 0 mm.

Example 231. A method of operating a CPM system comprising a foil lens corrector, the method comprising: directing a charged particle beam along an optical axis to a specimen positioned in a specimen plane; and operating a foil lens corrector positioned along the optical axis to generate a corrector electrostatic potential that generates an offsetting spherical aberration in the charged particle beam, wherein the foil lens corrector is the foil lens corrector of any example herein, particularly any one of examples 1-211.

Example 232. The method of any example herein, particularly example 231, wherein the operating the foil lens corrector comprises directing the charged particle beam to the foil such that the charged particle beam is incident upon the foil with a foil landing energy that is one or more of at least 5 kiloelectronvolts (keV), at least 7 keV, at least 10 keV, at least 15 keV, at least 20 keV, at least 30 keV, at least 50 keV, at 70 keV, at most 80 keV, at most 60 keV, at most 40 keV, at most 25 keV, at most 17 keV, at most 12 keV, at most 8 keV, at most 6 keV, 5-8 keV, 7-12 keV, 5-15 keV, 5-20 keV, 5-30 keV, 5-40 keV, 5-60 keV, or 5-80 keV.

Example 233. The method of any example herein, particularly any one of examples 231-232, wherein the operating the foil lens corrector comprises transmitting the charged particle beam through the foil with a transmission ratio that is one or more of at least 5%, at least 10%, at least 20%, at least 30%, at least 50%, at least 70%, at least 80%, at most 95%, at most 75%, at most 60%, at most 40%, at most 25%, at most 15%, or at most 7%.

Example 234. The method of any example herein, particularly any one of examples 231-233, wherein the operating the foil lens corrector comprises operating such that the offsetting spherical aberration is opposite in sign and at least substantially equal in magnitude to a spherical aberration component of the charged particle beam at the specimen plane when the foil lens corrector is omitted from the CPM system.

Example 235. The method of any example herein, particularly any one of examples 231-234, wherein the offsetting spherical aberration is characterized by a negative spherical aberration coefficient.

Example 236. The method of any example herein, particularly any one of examples 231-235, wherein the offsetting spherical aberration is characterized by a positive spherical aberration coefficient.

Example 237. The method of any example herein, particularly any one of examples 231-236, wherein the operating the foil lens corrector comprises generating, with the electrode assembly, the corrector electrostatic potential.

Example 238. The method of any example herein, particularly example 237, wherein the generating the corrector electrostatic potential comprises generating such that the corrector electrostatic potential is at least substantially constrained to a first side of the foil.

Example 239. The method of any example herein, particularly any one of examples 237-238, wherein the foil lens corrector comprises an electrode, and wherein the generating the corrector electrostatic potential comprises applying a voltage to the electrode.

Example 240. The method of any example herein, particularly any one of examples 237-239, wherein the electrode assembly comprises a first electrode and a second electrode, and wherein the generating the corrector electrostatic potential comprises applying a first voltage to the first electrode and applying a second voltage to the second electrode.

Example 241. The method of any example herein, particularly example 240, further comprising determining one or both of the first voltage and the second voltage.

Example 242. The method of any example herein, particularly any one of examples 240-241, further comprising determining a combination of the first voltage and the second voltage that will generate the offsetting spherical aberration in the charged particle beam.

Example 243. The method of any example herein, particularly any one of examples 240-242, further comprising: applying a predetermined first voltage to the first electrode; with the first electrode maintained at the predetermined first voltage, varying the second voltage applied to the second electrode; measuring a characteristic beam property of the charged particle beam corresponding to each second voltage as the second voltage is varied; and selecting a preferred second voltage corresponding to a preferred value of the characteristic beam property.

Example 244. The method of any example herein, particularly example 243, wherein the characteristic beam property comprises one or both of a characteristic beam diameter of the charged particle beam at the specimen plane and a spherical aberration of the charged particle beam at the specimen plane.

Example 245. The method of any example herein, particularly any one of examples 243-244, wherein the first voltage is the predetermined first voltage, and wherein the second voltage is the preferred second voltage.

Example 246. The method of any example herein, particularly any one of examples 231-245, wherein the CPM system comprises a booster tube configured to accelerate the charged particle beam within at least a portion of the CPM system, and wherein the method further comprises applying a booster tube voltage to the booster tube.

Example 247. The method of any example herein, particularly example 246, wherein the booster tube voltage is one or more of at least 5 kilovolts (kV), at least 7 kV, at least 10 kV, at most 12 kV, at most 8 kV, at most 6 kV, 5-8 kV, 7-12 kV, or 5-12 kV.

Example 248. The method of any example herein, particularly any one of examples 231-247, further comprising heating the foil with a corrector heater.

Example 249. The method of any example herein, particularly example 248, wherein the heating the foil comprises heating the foil to a temperature that is approximately 300 °C.

Example 250. The method of any example herein, particularly any one of examples 248-249, wherein the heating the foil comprises conveying thermal energy from a heating element of the corrector heater to the foil via a heater body that electrically isolates the heating element from the foil.

Example 251. The method of any example herein, particularly example 250, wherein the heater body comprises an electrically insulating portion and an electrically conductive portion.

Example 252. The method of any example herein, particularly any one of examples 250-251, wherein the electrically insulating portion is in direct contact with each of the heating element and the electrically conductive portion.

Example 253. The method of any example herein, particularly any one of examples 250-252, wherein the electrically insulating portion comprises aluminum nitride.

Example 254. The method of any example herein, particularly any one of examples 250-253, wherein the electrically conductive portion in direct contact with the foil.

Example 255. The method of any example herein, particularly any one of examples 250-254, further comprising a corrector housing that supports one or both of the foil and at least a portion of the electrode assembly, and wherein the electrically conductive portion is in direct contact with the corrector housing.

Example 256. The method of any example herein, particularly any one of examples 250-255, wherein the electrically conductive portion comprises molybdenum.

Example 257. The method of any example herein, particularly any one of examples 250-256, wherein the electrically conductive portion defines at least a portion of a heater conduit configured to allow the charged particle beam to pass through the heater body.

Example 258. The method of any example herein, particularly any one of examples 248-257, wherein the heating the foil with the corrector heater is performed prior to the directing the charged particle beam to the specimen.

Example 259. The method of any example herein, particularly any one of examples 231-258, wherein the directing the charged particle beam to the specimen comprises scanning, with one or more scanning deflectors of the CPM system, the charged particle beam relative to the specimen.

Example 260. The method of any example herein, particularly example 259, wherein the scanning the charged particle beam comprises scanning the charged particle beam across a region with a linear dimension that is one or more of at least 50 nm, at least 100 nm, at least 200 nm, at least 300 nm, at least 500 nm, at least 1000 nm, at most 1200 nm, at most 700 nm, at most 250 nm, at most 150 nm, or at most 75 nm.

Example 261. The method of any example herein, particularly any one of examples 231-260, wherein the directing the charged particle beam to the specimen comprises focusing the charged particle beam in a specimen plane to a spot with a characteristic diameter that is one or more of at least 0.1 nm, at least 0.5 nm, at least 1 nm, at least 3 nm, at least 5 nm, at most 10 nm, at most 4 nm, at most 2 nm, at most 0.7 nm, at most 0.2 nm, 0.2-1 nm, 0.5-5 nm, or 1-10 nm.

Example 262. The method of any example herein, particularly any one of examples 231-261, wherein the directing the charged particle beam to the specimen comprises directing such that the charged particle beam has a spherical aberration in a specimen plane that is characterized by a third order spherical aberration coefficient with a magnitude that is one or more of at most 5 mm, at most 3 mm, at most 1 mm, at most 0.5 mm, or 0 mm.

Example 263. A method of operating a CPM system comprising a foil lens corrector, the method comprising: directing a charged particle beam along an optical axis to a specimen positioned in a specimen plane; and operating a foil lens corrector positioned along the optical axis to generate a corrector electrostatic potential that generates an offsetting spherical aberration in the charged particle beam, wherein the operating the foil lens corrector comprises directing the charged particle beam to a foil of the foil lens corrector such that: (i) the charged particle beam is incident upon the foil with a foil landing energy that is at least 5 keV and at most 80 keV; and (ii) the charged particle beam is transmitted through the foil with a transmission ratio that is at least 20%.

Example 264. The method of any example herein, particularly example 263, wherein the operating the foil lens corrector comprises operating such that the offsetting spherical aberration is opposite in sign and at least substantially equal in magnitude to a spherical aberration component of the charged particle beam at the specimen plane when the foil lens corrector is omitted from the CPM system.

Example 265. The method of any example herein, particularly any one of examples 263-264, wherein the offsetting spherical aberration is characterized by a negative spherical aberration coefficient.

Example 266. The method of any example herein, particularly any one of examples 263-265, wherein the offsetting spherical aberration is characterized by a positive spherical aberration coefficient.

Example 267. The method of any example herein, particularly any one of examples 263-266, wherein the operating the foil lens corrector comprises generating, with an electrode assembly of the foil lens corrector, the corrector electrostatic potential.

Example 268. The method of any example herein, particularly example 267, wherein the generating the corrector electrostatic potential comprises generating such that the corrector electrostatic potential is at least substantially constrained to a first side of a foil of the foil lens corrector.

Example 269. The method of any example herein, particularly any one of examples 267-268, wherein the foil lens corrector comprises an electrode, and wherein the generating the corrector electrostatic potential comprises applying a voltage to the electrode.

Example 270. The method of any example herein, particularly any one of examples 267-269, wherein the electrode assembly comprises a first electrode and a second electrode, and wherein the generating the corrector electrostatic potential comprises applying a first voltage to the first electrode and applying a second voltage to the second electrode.

Example 271. The method of any example herein, particularly example 270, further comprising determining one or both of the first voltage and the second voltage.

Example 272. The method of any example herein, particularly any one of examples 270-271, further comprising determining a combination of the first voltage and the second voltage that will generate the offsetting spherical aberration in the charged particle beam.

Example 273. The method of any example herein, particularly any one of examples 270-272, further comprising: applying a predetermined first voltage to the first electrode; with the first electrode maintained at the predetermined first voltage, varying the second voltage applied to the second electrode; measuring a characteristic beam property of the charged particle beam corresponding to each second voltage as the second voltage is varied; and selecting a preferred second voltage corresponding to a preferred value of the characteristic beam property.

Example 274. The method of any example herein, particularly example 273, wherein the characteristic beam property comprises one or both of a characteristic beam diameter of the charged particle beam at the specimen plane and a spherical aberration of the charged particle beam at the specimen plane.

Example 275. The method of any example herein, particularly any one of examples 273-274, wherein the first voltage is the predetermined first voltage, and wherein the second voltage is the preferred second voltage.

Example 276. The method of any example herein, particularly any one of examples 273-275, wherein the CPM system comprises a booster tube configured to accelerate the charged particle beam within at least a portion of the CPM system, and wherein the method further comprises applying a booster tube voltage to the booster tube.

Example 277. The method of any example herein, particularly example 276, wherein the booster tube voltage is one or more of at least 5 kilovolts (kV), at least 7 kV, at least 10 kV, at most 12 kV, at most 8 kV, at most 6 kV, 5-8 kV, 7-12 kV, or 5-12 kV.

Example 278. The method of any example herein, particularly any one of examples 263-277, further comprising heating the foil of the foil lens corrector with a corrector heater.

Example 279. The method of any example herein, particularly example 278, wherein the heating the foil comprises heating the foil to a temperature that is approximately 300 °C.

Example 280. The method of any example herein, particularly any one of examples 278-279, wherein the heating the foil comprises conveying thermal energy from a heating element of the corrector heater to the foil via a heater body that electrically isolates the heating element from the foil.

Example 281. The method of any example herein, particularly example 280, wherein the heater body comprises an electrically insulating portion and an electrically conductive portion.

Example 282. The method of any example herein, particularly any one of examples 280-281, wherein the electrically insulating portion is in direct contact with each of the heating element and the electrically conductive portion.

Example 283. The method of any example herein, particularly any one of examples 280-282, wherein the electrically insulating portion comprises aluminum nitride.

Example 284. The method of any example herein, particularly any one of examples 280-283, wherein the electrically conductive portion in direct contact with the foil.

Example 285. The method of any example herein, particularly any one of examples 280-284, further comprising a corrector housing that supports one or both of the foil and at least a portion of an electrode assembly of the foil lens corrector, and wherein the electrically conductive portion is in direct contact with the corrector housing.

Example 286. The method of any example herein, particularly any one of examples 280-285, wherein the electrically conductive portion comprises molybdenum.

Example 287. The method of any example herein, particularly any one of examples 280-286, wherein the electrically conductive portion defines at least a portion of a heater conduit configured to allow the charged particle beam to pass through the heater body.

Example 288. The method of any example herein, particularly any one of examples 278-287, wherein the heating the foil with the corrector heater is performed prior to the directing the charged particle beam to the specimen.

Example 289. The method of any example herein, particularly any one of examples 273-288, wherein the directing the charged particle beam to the specimen comprises scanning, with one or more scanning deflectors of the CPM system, the charged particle beam relative to the specimen.

Example 290. The method of any example herein, particularly example 289, wherein the scanning the charged particle beam comprises scanning the charged particle beam across a region with a linear dimension that is one or more of at least 50 nm, at least 100 nm, at least 200 nm, at least 300 nm, at least 500 nm, at least 1000 nm, at least 1200 nm, at most 700 nm, at most 250 nm, at most 150 nm, or at most 75 nm.

Example 291. The method of any example herein, particularly any one of examples 273-290, wherein the directing the charged particle beam to the specimen comprises focusing the charged particle beam in a specimen plane to a spot with a characteristic diameter that is one or more of at least 0.1 nm, at least 0.5 nm, at least 1 nm, at least 3 nm, at least 5 nm, at most 10 nm, at most 4 nm, at most 2 nm, at most 0.7 nm, at most 0.2 nm, 0.2-1 nm, 0.5-5 nm, or 1-10 nm.

Example 292. The method of any example herein, particularly any one of examples 273-291, wherein the directing the charged particle beam to the specimen comprises directing such that the charged particle beam has a spherical aberration in a specimen plane that is characterized by a third order spherical aberration coefficient with a magnitude that is one or more of at most 5 mm, at most 3 mm, at most 1 mm, at most 0.5 mm, or 0 mm.

Example 293. A method of operating a CPM system comprising a foil lens corrector, the method comprising: directing a charged particle beam along an optical axis to a specimen positioned in a specimen plane; and operating a foil lens corrector positioned along the optical axis as a convergent lens to generate a corrector electrostatic potential that generates an offsetting spherical aberration in the charged particle beam, wherein the foil lens corrector comprises a foil and an electrode assembly, and wherein the operating the foil lens corrector comprises generating, with the electrode assembly, the corrector electrostatic potential only on a first side of the foil.

Example 294. The method of any example herein, particularly example 293, wherein the operating the foil lens corrector comprises directing the charged particle beam to the foil such that the charged particle beam is incident upon the foil with a foil landing energy that is one or more of at least 5 kiloelectronvolts (keV), at least 7 keV, at least 10 keV, at least 15 keV, at least 20 keV, at least 30 keV, at least 50 keV, at 70 keV, at most 80 keV, at most 60 keV, at most 40 keV, at most 25 keV, at most 17 keV, at most 12 keV, at most 8 keV, at most 6 keV, 5-8 keV, 7-12 keV, 5-15 keV, 5-20 keV, 5-30 keV, 5-40 keV, 5-60 keV, or 5-80 keV.

Example 295. The method of any example herein, particularly any one of examples 293-294, wherein the operating the foil lens corrector comprises transmitting the charged particle beam through the foil with a transmission ratio that is one or more of at least 5%, at least 10%, at least 20%, at least 30%, at least 50%, at least 70%, at least 80%, at most 95%, at most 75%, at most 60%, at most 40%, at most 25%, at most 15%, and/or at most 7%.

Example 296. The method of any example herein, particularly any one of examples 293-295, wherein the operating the foil lens corrector comprises operating such that the offsetting spherical aberration is opposite in sign and at least substantially equal in magnitude to a spherical aberration component of the charged particle beam at the specimen plane when the foil lens corrector is omitted from the CPM system.

Example 297. The method of any example herein, particularly any one of examples 293-296, wherein the offsetting spherical aberration is characterized by a negative spherical aberration coefficient.

Example 298. The method of any example herein, particularly any one of examples 293-297, wherein the offsetting spherical aberration is characterized by a positive spherical aberration coefficient.

Example 299. The method of any example herein, particularly any one of examples 283-298, wherein the operating the foil lens corrector comprises generating, with the electrode assembly, the corrector electrostatic potential.

Example 300. The method of any example herein, particularly example 299, wherein the generating the corrector electrostatic potential comprises generating such that the corrector electrostatic potential is at least substantially constrained to a first side of the foil.

Example 301. The method of any example herein, particularly any one of examples 299-300, wherein the foil lens corrector comprises an electrode, and wherein the generating the corrector electrostatic potential comprises applying a voltage to the electrode.

Example 302. The method of any example herein, particularly any one of examples 299-301, wherein the electrode assembly comprises a first electrode and a second electrode, and wherein the generating the corrector electrostatic potential comprises applying a first voltage to the first electrode and applying a second voltage to the second electrode.

Example 303. The method of any example herein, particularly example 302, further comprising determining one or both of the first voltage and the second voltage.

Example 304. The method of any example herein, particularly any one of examples 302-303, further comprising determining a combination of the first voltage and the second voltage that will generate the offsetting spherical aberration in the charged particle beam.

Example 305. The method of any example herein, particularly any one of examples 302-304, further comprising: applying a predetermined first voltage to the first electrode; with the first electrode maintained at the predetermined first voltage, varying the second voltage applied to the second electrode; measuring a characteristic beam property of the charged particle beam corresponding to each second voltage as the second voltage is varied; and selecting a preferred second voltage corresponding to a preferred value of the characteristic beam property.

Example 306. The method of any example herein, particularly example 305, wherein the characteristic beam property comprises one or both of a characteristic beam diameter of the charged particle beam at the specimen plane and a spherical aberration of the charged particle beam at the specimen plane.

Example 307. The method of any example herein, particularly any one of examples 305-306, wherein the first voltage is the predetermined first voltage, and wherein the second voltage is the preferred second voltage.

Example 308. The method of any example herein, particularly any one of examples 293-307, wherein the CPM system comprises a booster tube configured to accelerate the charged particle beam within at least a portion of the CPM system, and wherein the method further comprises applying a booster tube voltage to the booster tube.

Example 309. The method of any example herein, particularly example 308, wherein the booster tube voltage is one or more of at least 5 kilovolts (kV), at least 7 kV, at least 10 kV, at most 12 kV, at most 8 kV, at most 6 kV, 5-8 kV, 7-12 kV, or 5-12 kV.

Example 310. The method of any example herein, particularly any one of examples 293-309, further comprising heating the foil with a corrector heater.

Example 311. The method of any example herein, particularly example 310, wherein the heating the foil comprises heating the foil to a temperature that is approximately 300 °C.

Example 312. The method of any example herein, particularly any one of examples 310-311, wherein the heating the foil comprises conveying thermal energy from a heating element of the corrector heater to the foil via a heater body that electrically isolates the heating element from the foil.

Example 313. The method of any example herein, particularly example 312, wherein the heater body comprises an electrically insulating portion and an electrically conductive portion.

Example 314. The method of any example herein, particularly any one of examples 312-313, wherein the electrically insulating portion is in direct contact with each of the heating element and the electrically conductive portion.

Example 315. The method of any example herein, particularly any one of examples 312-314, wherein the electrically insulating portion comprises aluminum nitride.

Example 316. The method of any example herein, particularly any one of examples 312-315, wherein the electrically conductive portion in direct contact with the foil.

Example 317. The method of any example herein, particularly any one of examples 312-316, further comprising a corrector housing that supports one or both of the foil and at least a portion of the electrode assembly, and wherein the electrically conductive portion is in direct contact with the corrector housing.

Example 318. The method of any example herein, particularly any one of examples 312-317, wherein the electrically conductive portion comprises molybdenum.

Example 319. The method of any example herein, particularly any one of examples 312-318, wherein the electrically conductive portion defines at least a portion of a heater conduit configured to allow the charged particle beam to pass through the heater body.

Example 320. The method of any example herein, particularly any one of examples 310-319, wherein the heating the foil with the corrector heater is performed prior to the directing the charged particle beam to the specimen.

Example 321. The method of any example herein, particularly any one of examples 293-320, wherein the directing the charged particle beam to the specimen comprises scanning, with one or more scanning deflectors of the CPM system, the charged particle beam relative to the specimen.

Example 322. The method of any example herein, particularly example 321, wherein the scanning the charged particle beam comprises scanning the charged particle beam across a region with a linear dimension that is one or more of at least 50 nm, at least 100 nm, at least 200 nm, at least 300 nm, at least 500 nm, at least 1000 nm, at most 1200 nm, at most 700 nm, at most 250 nm, at most 150 nm, or at most 75 nm.

Example 323. The method of any example herein, particularly any one of examples 293-322, wherein the directing the charged particle beam to the specimen comprises focusing the charged particle beam in a specimen plane to a spot with a characteristic diameter that is one or more of at least 0.1 nm, at least 0.5 nm, at least 1 nm, at least 3 nm, at least 5 nm, at most 10 nm, at most 4 nm, at most 2 nm, at most 0.7 nm, at most 0.2 nm, 0.2-1 nm, 0.5-5 nm, or 1-10 nm.

Example 324. The method of any example herein, particularly any one of examples 293-323, wherein the directing the charged particle beam to the specimen comprises directing such that the charged particle beam has a spherical aberration in a specimen plane that is characterized by a third order spherical aberration coefficient with a magnitude that is one or more of at most 5 mm, at most 3 mm, at most 1 mm, at most 0.5 mm, or 0 mm.

In view of the many possible examples in which the principles of the disclosed technology may be applied, it should be recognized that the illustrated examples are only preferred examples and should not be taken as limiting the scope of the disclosed technology. Rather, the scope is defined by the following claims. We therefore claim all that comes within the scope of these claims.

## Claims

1. A foil lens corrector for correcting spherical aberration in a charged particle beam generated by a charged particle microscope (CPM) system, the foil lens corrector comprising:
a foil configured to be positioned in line with an optical axis of the CPM system; and
an electrode assembly configured to generate a corrector electrostatic potential,
wherein the foil comprises graphene, wherein the foil is configured to support a space charge such that the optical axis intersects the space charge, and wherein the foil lens corrector is configured such that the corrector electrostatic potential generates an offsetting spherical aberration in the charged particle beam to at least partially correct a spherical aberration in the charged particle beam.

2. The foil lens corrector of claim 1, wherein the foil lens corrector is configured to operate as a convergent lens upon the charged particle beam.

3. The foil lens corrector of claim 1, wherein the foil lens corrector is configured such that, during operative use of the CPM system, the charged particle beam is incident upon the foil with a foil landing energy that is at least 5 keV and at most 80 keV and the charged particle beam is transmitted through the foil with a transmission ratio that is at least 20%.

4. The foil lens corrector of claim 1, wherein the electrode assembly is configured to generate the corrector electrostatic potential on a first side of the foil, and wherein the foil is configured to shield the corrector electrostatic potential such that a maximum magnitude of the corrector electrostatic potential generated by the electrode assembly on a second side of the foil opposite to the first side of the foil is at most 1% of a maximum magnitude of the corrector electrostatic potential on the first side of the foil.

5. The foil lens corrector of claim 1, wherein the electrode assembly comprises a first electrode and a second electrode positioned on a common side of the foil, and wherein the foil lens corrector is configured to generate at least a portion of the corrector electrostatic potential by applying a first electrode voltage to the first electrode and applying a second electrode voltage to the second electrode while the foil is maintained at a foil potential that is different from each of the first electrode voltage and the second electrode voltage.

6. The foil lens corrector of claim 1, further comprising a shielding electrode that defines a foil aperture with a foil aperture diameter that is at least 100 microns (µm), wherein the foil extends across the foil aperture, and wherein the foil is freestanding across the foil aperture.

7. The foil lens corrector of claim 1, further comprising a corrector housing that supports one or both of the foil and at least a portion of the electrode assembly, wherein the electrode assembly comprises one or more electrodes configured to generate at least a portion of the corrector electrostatic potential, and wherein the corrector housing supports one or more electrodes at least partially within corrector housing such that one or more electrodes are electrically insulated from the corrector housing.

8. The foil lens corrector of claim 1, further comprising a corrector heater configured to heat the foil, wherein the corrector heater comprises a heating element configured to receive an electrical current and a heater body, wherein the heating element is thermally coupled to the foil via the heater body, and wherein the heating element is electrically isolated from the foil.

9. The foil lens corrector of claim 1, wherein the foil lens corrector is at least partially positioned within a booster tube within a booster tube of the CPM system, the booster tube being configured to accelerate the charged particle beam within at least a portion of the CPM system.

10. The foil lens corrector of claim 9, wherein the foil is electrically coupled to the booster tube.

11. A method of operating a CPM system, the method comprising:
directing a charged particle beam along an optical axis to a specimen positioned in a specimen plane; and
operating a foil lens corrector positioned along the optical axis to generate a corrector electrostatic potential that generates an offsetting spherical aberration in the charged particle beam,
wherein the operating the foil lens corrector comprises directing the charged particle beam to a foil of the foil lens corrector such that:
the charged particle beam is incident upon the foil with a foil landing energy that is at least 5 keV and at most 80 keV; and
the charged particle beam is transmitted through the foil with a transmission ratio that is at least 20%.

12. The method of claim 11, wherein the operating the foil lens corrector comprises operating such that the offsetting spherical aberration is opposite in sign and at least substantially equal in magnitude to a spherical aberration component of the charged particle beam at the specimen plane when the foil lens corrector is omitted from the CPM system.

13. The method of claim 11, wherein the operating the foil lens corrector comprises operating such that the corrector electrostatic potential is at least substantially constrained to a first side of the foil.

14. The method of claim 13, wherein the electrode assembly comprises a first electrode and a second electrode, wherein the generating the corrector electrostatic potential comprises applying a first voltage to the first electrode and applying a second voltage to the second electrode, and wherein the method further comprises determining a combination of the first voltage and the second voltage that will generate the offsetting spherical aberration in the charged particle beam.

15. The method of claim 11, further comprising, prior to the directing the charged particle beam to the specimen, heating the foil with a corrector heater.
